(19) **Europäisches Patentamt / European Patent Office / Office européen des brevets**

(11) **EP 4 390 421 B1**

(12) **EUROPEAN PATENT SPECIFICATION**

(45) Date of publication and mention
of the grant of the patent:
**23.07.2025 Bulletin 2025/30**

(21) Application number: **22216134.1**

(22) Date of filing: **22.12.2022**

(51) International Patent Classification (IPC):
**G01R 31/392** (2019.01)

(52) Cooperative Patent Classification (CPC):
**G01R 31/392; G01R 31/367**

(54) **A METHOD FOR ESTIMATION STATE OF HEALTH OF A BATTERY**

VERFAHREN ZUR SCHÄTZUNG DES GESUNDHEITSZUSTANDS EINER BATTERIE

PROCÉDÉ D'ESTIMATION DE L'ÉTAT DE SANTÉ D'UNE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**26.06.2024 Bulletin 2024/26**

(73) Proprietors:
• **Ningbo Geely Automobile Research & Development Co., Ltd.**
**Ningbo, Zhejiang 315336 (CN)**
• **Zhejiang Geely Holding Group Co., Ltd.**
**Hangzhou, Zhejiang 310051 (CN)**

(72) Inventors:
• **ZHANG, Yizhou**
**43151 Mölndal (SE)**
• **ZOU, Changfu**
**41326 Göteborg (SE)**
• **WIK, Torsten**
**41672 Göteborg (SE)**

(74) Representative: **Zacco Sweden AB**
**P.O. Box 5581**
**Löjtnantsgatan 21**
**114 85 Stockholm (SE)**

(56) References cited:
**US-B2- 11 360 155**

• LIU GENGFENG ET AL: "State of health estimation of power batteries based on multi-feature fusion models using stacking algorithm", ENERGY, ELSEVIER, AMSTERDAM, NL, vol. 259, 31 July 2022 (2022-07-31), XP087184363, ISSN: 0360-5442, [retrieved on 20220731], DOI: 10.1016/J.ENERGY.2022.124851

• XIAO ZHOUXIAO ET AL: "Remaining Useful Life Prediction of Lithium-ion Battery Based on Unscented Kalman Filter and Back propagation Neural Network", 2019 IEEE 8TH DATA DRIVEN CONTROL AND LEARNING SYSTEMS CONFERENCE (DDCLS), IEEE, 24 May 2019 (2019-05-24), pages 47 - 52, XP033641514, DOI: 10.1109/DDCLS.2019.8908952

• YAN LISEN ET AL: "A hybrid method with cascaded structure for early-stage remaining useful life prediction of lithium-ion battery", ENERGY, ELSEVIER, AMSTERDAM, NL, vol. 243, 31 December 2021 (2021-12-31), XP086950679, ISSN: 0360-5442, [retrieved on 20211231], DOI: 10.1016/J.ENERGY.2021.123038

EP 4 390 421 B1

**Description**

TECHNICAL FIELD

The present disclosure relates to method for estimation of state of health (SoH) of a rechargeable battery. The disclosure further relates to a corresponding system.

Moreover, even if the method and system according to the disclosure will be described primarily in relation to a car, the method and system is not restricted to this particular vehicle, but may as well be installed or implemented in another type of vehicle, such as a truck, a bus, a rail vehicle, a flying vehicle, a marine vessel, an off-road vehicle, a mining vehicle, an agriculture vehicle, or a working vehicle, or the like. In fact, the method and system according to the disclosure may alternatively be used for estimation SoH of stationary batteries, such as for example large-scale grid battery power storage or home battery power storage.

BACKGROUND

Thanks to environmental concerns, regulatory pressure, and technological advancement, electrification in the automotive industry have become an irreversible trend. Accurately estimating the battery state of health (SoH) under various usage profiles is indispensable for timely maintenance, optimizing energy management, and customer satisfaction. The dynamic operating conditions, random user behaviours, and cell-to-cell variations make battery SoH estimation challenging for real applications. Prior art document "State of health estimation of power batteries based on multi-feature fusion models using stacking algorithm", by Liu Gengfeng, ENERGY, ELSEVIER, AMSTERDAM, NL, vol. 259, 31 July 2022, XP087184363, discloses estimating state of health of a battery using a multi-feature fusion model, where two different machine learning based estimates are fused using a stacking algorithm.

There is thus a need for an improved method for estimating battery SoH.

SUMMARY

An object of the present disclosure is to provide an improved method and system for battery SoH estimation. This object is at least partly achieved by the features of the independent claims. The dependent claims contain further developments of the method and system.

According to a first aspect of the present disclosure, there is provided a method for estimation of state of health of a rechargeable battery, the method comprising: obtaining input data of a set of predetermined battery features that jointly indicates State of Health of the battery; applying a plurality of machine learning algorithms to conduct state of health estimation of the battery, wherein each machine learning algorithm, based on obtained input data from the battery features, calculates an estimation of state of health of the battery, as well as quantitative estimation of a confidence interval/value of the state of health estimation of the battery; and applying a Kalman filter (KF)-based fusion algorithm for combining the state of health estimations from all of said plurality of machine learning algorithms, for providing a fused state of health estimation.

According to a second aspect of the present disclosure, there is provided a system for estimation of state of health of a rechargeable battery, the system comprising: a rechargeable battery; a set of sensors configured for sensing a set of battery features on the rechargeable battery, wherein the set of battery features jointly indicate State of Health of the battery; and an electronic control unit connected with the set of sensors, wherein an electronic control unit is configured to: obtain input data relating to the set of predetermined battery features; apply a plurality of machine learning algorithms to conduct state of health estimation of the battery, wherein each machine learning algorithm, based on obtained input data from the battery features, calculates an estimation of state of health of the battery, as well as quantitative estimation of a confidence interval/value of the state of health estimation of the battery; and apply a Kalman filter (KF)-based fusion algorithm for combining the state of health estimations from all of said plurality of machine learning algorithms, for providing a fused state of health estimation.

In this way, a method is provided that more accurately and reliably estimates SoH of posed a battery, even when battery is subjected to arbitrary usage profiles are . After categorizing various operating conditions, an appropriate feature set is extracted to indicate battery aging states for each category. Multiple machine learning algorithms are deployed for online SoH estimation with the obtained features. Based on an SoH prediction model recently developed using machine learning and usage-related histogram data, a Kalman filter is designed to fuse all the estimates optimally and in real-time. Experimental data on batteries of different types and under different operating profiles have verified the efficacy and practicability of the developed method.

Further advantages are achieved by implementing one or several of the features of the dependent claims.

The term "input data" used herein refers mainly to streaming data or online data, i.e. data which is measured online, for example by means of a Battery Management System (BMS) and are used to feed into the machine learning pipeline to make the estimation.

In some example embodiments, the obtained input data is acquired in connection with a battery charging phase. Compared to discharging processes that are unpredictable and stochastic, the charging profiles are more predictable, such as for the constant current-constant voltage (CC-CV) scheme that is adopted widely in commercial BMSs. Hence, since the charging event is relatively predetermined and well-defined in terms of required time period, charging current, charging profile, etc., battery SoH estimation based on battery charging phase produces is general more accurate estimations.

In some example embodiments, that may be combined with any one or more of the above-described embodiments, the method further includes a setup phase performed before the step of obtaining input data, wherein the setup phase comprises training the machine learning algorithms.

In some example embodiments, that may be combined with any one or more of the above-described embodiments, the predetermined battery features includes one or more of the following battery features, based on the latest battery charging event:

voltage curve profile; current curve profile; time interval between a predefined voltage window; signal strength over time, which is calculated as $E = \int_0^\infty s(t)^2 dt$, where s(t) is the signal; the area under the current curve; the area under the voltage curve; the slope of the voltage curve; the slope of the current curve; initial SoC; final SoC, charging temperature-related features; incremental capacity curve peak value; incremental capacity curve voltage level at peak value; final total battery output voltage; final individual cell voltage; and differential voltage curve. These battery features are deemed to provide a relatively strong indication of battery SoH.

In some example embodiments, that may be combined with any one or more of the above-described embodiments, the method further includes a setup phase comprising selecting a set of unique charging scenarios (S1-S5), each having an unique charging start and/or charging stop position; and training the machine learning algorithms separately for each of the selected charging scenario S1-S5 and based on a data set that corresponds to the selected charging scenario S1-S5, wherein the step of obtaining input data involves determining which one of the unique charging scenarios (S1-S5) the obtained input data corresponds to, and wherein the step of applying a plurality of machine learning algorithms to conduct state of health estimation of the battery involves, for each of the machine learning algorithms, applying the machine learning algorithm that is trained on data associated with the determined charging scenario (S1-S5) for calculating said estimation of state of health of the battery, as well as said quantitative estimation of a confidence interval/value of the state of health estimation of the battery. Due to random user behaviours, the State of Charge (SoC) range may frequently vary over different charging cycles in actual EV usage, thereby causing the machine learning algorithms to preform less accurately and reliably. However, by providing machine learning algorithms that are trained on a set of individual predetermined partial charging curves, the SoH estimation output of the machine learning algorithms may be significantly improved by selecting the ML algorithm that is trained based on a charging scenario that is most similar the most recent real charging scenario.

In some example embodiments, that may be combined with any one or more of the above-described embodiments, one set of predetermined battery features indicating State of Health of the battery is selected for each charging scenario (S1-S5) of the set of unique charging scenarios (S1-S5), and wherein the predetermined battery features of at least one charging scenario (S1-S5) of the set of unique charging scenarios (S1-S5) differs from the predetermined battery features of another charging scenario (S1-S5) of the set of unique charging scenarios (S1-S5). The most appropriate battery features may in some examples be the same for different charging scenarios, but generally, a unique set of battery features is applicable for at one charging scenario, specifically each charging scenario, for providing improved battery SoH estimation.

In some example embodiments, that may be combined with any one or more of the above-described embodiments, each of the sets of predetermined battery features indicating State of Health of the battery is determined by: first identifying a set of preliminary battery features that jointly indicates state of health of the battery, and then performing a correlation analysis of the preliminary battery features. The purpose of the correlation analysis is to eliminate redundant features and thus improving estimation quality and/or calculation efficiency.

In some example embodiments, that may be combined with any one or more of the above-described embodiments, method further comprising: calculating a battery SoH prediction by means of a histogram data-based machine learning prediction model, as well as quantitative estimation of a confidence interval/value of said battery SoH prediction, and applying said Kalman filter (KF)-based fusion algorithm for combining the battery state of health estimations from all of said plurality of machine learning algorithms and the battery SoH prediction from said histogram data-based machine learning prediction model for providing a fused battery state of health estimation.

For a given battery charging profile, the predefined scenarios S1-S5 may not be appropriate for various reasons. For example, the give charging scenario may be correspond to any of the predefined scenarios S1-S5, or the given battery charging profile may include data corruption, communication delay/faults, etc. Under such circumstances, the selected features cannot be extracted using any of charging scenarios S1-S5, thereby rendering all the ML models discussed above infeasible. In such a situation, the battery SoH estimation may be accurately be performed by histogram data-based model for capacity prediction instead, because this predictor mode is less dependent on the given charging scenario and thus more robust.

In some example embodiments, that may be combined with any one or more of the above-described embodiments, the step of calculating battery SoH prediction by means of a histogram data-based machine learning prediction model involves a setup phase that includes: obtaining historical battery usage data, converting battery usage data to 1D histogram and extracting statistical properties from said 1D histogram, determining battery features based on extracting statistical properties, providing a global model by selecting and offline training of a machine learning algorithm based on the obtained historical battery usage data, and wherein the step of calculating battery SoH prediction by means of a histogram data-based machine learning prediction model during online use of the battery involves: calculating a global prediction of the battery SoH based on the global model; and adapting the global prediction of the battery SoH online based on measured historical battery capacity estimation values of the present battery (5) for providing a final battery SoH prediction.

In some example embodiments, that may be combined with any one or more of the above-described embodiments, the set of unique', the set of full and/or] charging scenarios (S1-S5) includes one or more of the following battery charging scenarios: Complete full Constant Current (CC) - Constant Voltage (CV) charging; partial CC-CV charging involving starting after the Incremental Capacity (IC) curve peak value and ending with the complete Constant Voltage (CV) phase; partial Constant Current (CC) - Constant Voltage (CV) charging when starting after the Incremental Capacity (IC) curve peak value and ending without Constant Voltage (CV) phase; Partial Constant Current (CC) - Constant Voltage (CV) charging when starting before the Incremental Capacity (IC) curve peak value and ending with the complete Constant Voltage (CV) phase; Partial Constant Current (CC) - Constant Voltage (CV) charging when starting before the IC peak value and ending without Constant Voltage (CV) phase.

In some example embodiments, that may be combined with any one or more of the above-described embodiments, the method further comprises the step of setting the battery state of health estimation equal to the battery SoH prediction as derived by means of the histogram data-based machine learning prediction model when the obtained input data does not correspond to any of the set of unique charging scenarios (S1-S5). In other words, the Kalman filter may be bypassed during those charging events that that does not correspond to any of the trained charging scenarios, and only the histogram data-based machine learning prediction model provides a single reasonable SoH estimate, because there is no purpose of fusing a single SoH prediction.

The disclosure also relates to a vehicle comprising the system as descried above.

The disclosure also relates to a data processing control unit comprising a processor configured to perform the steps of the method described above.

The disclosure also relates to a computer program comprising instructions which, when the program is executed by a computer, cause the computer to carry out the steps of the method as described above.

Further features and advantages of the invention will become apparent when studying the appended claims and the following description. The skilled person in the art realizes that different features of the present disclosure may be combined to create embodiments other than those explicitly described hereinabove and below, without departing from the scope of the present disclosure.

BRIEF DESCRIPTION OF DRAWINGS

The method and system according to the disclosure will be described in detail in the following, with reference to the attached drawings, in which

Fig. 1 shows schematically a side-view of a battery electric vehicle having system of the disclosure,

Fig. 2 shows the basic steps of the method according to the disclosure,

Fig. 3A-3E show various graphs of battery charging and discharging profiles,

Fig. 4A-4C show various graphs of a plurality of battery capacity profiles over time,

Fig. 5 shows a flowchart of an example embodiment of the method according to the disclosure,

Fig. 6 shows a flowchart of a further example embodiment of the method according to the disclosure,

Fig. 7-8 show two example embodiments of a flowchart describing how to identify suitable battery features for the ML algorithms according to the disclosure,

Fig. 9-10    show two different illustrations of the structure of the model for calculating a battery SoH prediction by means of a histogram data-based machine learning prediction model according to the disclosure,

Fig.11    shows a flowchart of a further example embodiment of the method according to the disclosure,

Fig. 12A-E    show the selected final battery features for five different example charging scenarios according to the disclosure,

Fig. 13    shows the capacity estimation results for a certain battery type under different charging scenarios,

Fig. 14A-C    show estimation results of a randomly selected battery cell under a certain charging scenario.

Fig. 15    shows the standard deviation of the results from the best model, the worst model, and the model fusion for a randomly selected cell,

Fig. 16A-D    show capacity estimation results of a randomly selected battery cell under practical charging cycles.,

Fig. 17A-E    show various example flowcharts describing the main steps of the method according to the disclosure.

DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

Those skilled in the art will appreciate that the steps, services and functions explained herein may be implemented using individual hardware circuitry, using software functioning in conjunction with a programmed microprocessor or general purpose computer, using one or more Application Specific Integrated Circuits (ASICs) and/or using one or more Digital Signal Processors (DSPs). It will also be appreciated that when the present disclosure is described in terms of a method, it may also be embodied in one or more processors and one or more memories coupled to the one or more processors, wherein the one or more memories store one or more programs that perform the steps, services and functions disclosed herein when executed by the one or more processors.

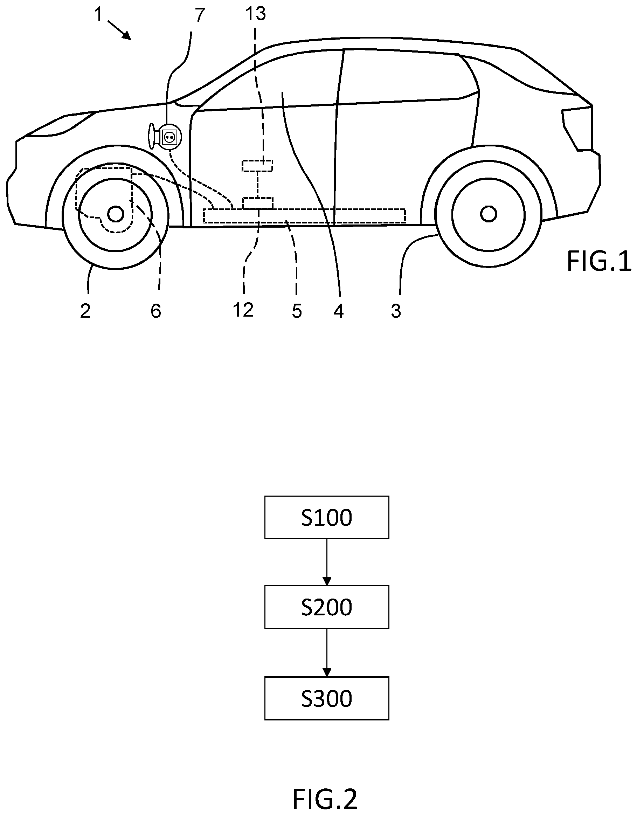

The present method and system estimation of state of health of a rechargeable battery may be implemented in various types of battery powered applications, such as in particular electrical vehicle applications, but also relevant in for example stationary battery applications, such as for example large-scale grid battery power storage or home battery power storage. The present disclosure will describe the method and system estimation of state of health of a rechargeable battery primarily for use in a battery powered electric vehicle, as schematically illustrated in figure 1.

Specifically, figure 1 shows a side view of an electric vehicle 1 having front wheels 2a, rear wheels 2b, a passenger compartment 3 and an electric vehicle drivetrain, which includes a high-voltage battery 6 connected to an electrical machine 5, for example via a power converter such as an inverter or the like. An output shaft of the electric machine 5 is drivingly connected the front and/or rear wheels 2a, 2b, of the vehicle. The drivetrain further comprises a charging inlet 4 configured for receiving a charging connector of a charging station during charging of the high-voltage battery 6.

During charging of the high-voltage battery 6, electrical charge is supplied to the high-voltage battery 6 from the charging station via the charging inlet 4, and during vehicle driving, electrical charge is supplied from the high-voltage battery 6 to the electrical machine 5 for propulsion of the vehicle.

Massive electrification in the transportation sector has become an unstoppable global trend thanks to the ever-growing environmental consciousness of the public, stringent regulations on vehicle emissions, and advancements in electric propulsion and energy storage technology. Automakers are increasingly shifting from the combustion engine centred powertrain architecture toward an electrified solution. Many of them have made bold commitments to electrify all their product portfolios by 2025 and stop selling combustion engine vehicles by as early as 2030. Lithium-ion batteries play an essential role in this transition because of their high energy density, relatively low cost, and long lifetime. As one of the most critical and expensive vehicle components, the battery attracts tremendous attention from the industry and academia. Among different properties, aging is pivotal as it weakens the battery performance and reliability, deteriorates the state of health (SoH), and increases the risk of safety hazards. Furthermore, such a process can be easily accelerated if the battery is used inappropriately. Therefore, for optimal energy management, timely maintenance, and accurate residual value prediction, it is vital to understand the aging process and monitor SoH in real-time.

Generally speaking, the existing methods for battery SoH estimation can broadly be categorized into empirical, model-based, and data-driven methods. Based on extensive laboratory cycling data, empirical methods typically use polynomial, exponential, or quadratic functions to fit the battery aging trend. These methods commonly rely on a hypothesis of regular cycling profiles. However, batteries deployed in electrified vehicles (EVs) encounter irregular and complicated operating conditions, which inevitably undermines the accuracy and reliability of these estimation methods.

In contrast to an open-loop estimation of the empirical method, model-based methods adopt a closed-loop solution. Two different kinds of models are commonly employed, i.e., equivalent circuit models (ECMs) developed from Kirchhoff's laws and electrochemical models (EMs) derived from porous electrode theory [10]. Because of their structural simplicity and ease of implementation, ECMs have been extensively studied and applied to battery aging prognostics. However, the fidelity of such models degrades when the profiles experienced in real-world applications differ from those of laboratory characteristic profiles and model parameters diverge from the true value due to lack of regular reference performance tests. EMs have the capability of modelling local dynamics within a battery, including aging mechanisms, e.g., solid electrolyte interface growth, lithium plating, and particle cracking. However, the high computation requirement and the difficulty of model parameterization make this kind of model hard to use in online applications.

Many research attempts have recently been made to apply data-driven methods to battery SoH estimation because they are flexible, mechanism-agnostic, and have the capability of recognizing patterns and trends under complex dynamic situations. Feature construction is generally one of the relevant steps for such methods, as the performance of ML algorithms will generally significantly depend on if the selected battery features contain enough information to indicate the aging state of the battery or not. A typical battery management system (BMS) only measures the individual cell voltage and the pack current, together with one or two temperature sensors for each module in the pack. Hence, selecting features based on the information available in real-world battery systems is preferred.

Depending on the implementation and charging and discharging profiles, battery features indicating battery SoH can be derived from both the charging and discharging process. It is however sometimes preferred to rely primarily, or even only, on the charging process, such in vehicle applications, because the uncontrolled operating conditions of vehicle end-users, especially the discharging phase with intermittent regenerative braking and potentially long parking time causing calendar aging, can pose significant challenges to the applicability of such a method. Compared to discharging processes that are often unpredictable and stochastic, the vehicle charging profiles are easy to control, e.g., the constant current-constant voltage (CC-CV) scheme that is adopted widely in commercial BMSs. This has attracted great research interest in using CC-CV charging curves for SoH estimation.

Incremental capacity (IC) and differential voltage (DV) curves that are usually used for the analysis of battery aging mechanisms can also be used to estimate battery SoH. To do so, characteristic values associated with the peaks or valleys of IC/DV curves, e.g., the height, are typically selected as features. However, in certain battery applications, such as for example battery electric vehicles, the SoC range may frequently vary over different charging cycles in actual EV usage due to random user behaviours. Since the peaks and valleys of the IC profile only appear at specific voltage windows, the corresponding estimator becomes useless when such a window does not show up in the charging realization. This solicits research endeavours to develop reliable estimators from partial charging curves, thereby rendering the battery SoH estimator particularly robust for battery electric vehicle implementations.

Partial charging curves are for example provided by first cycling a battery under a first partial charge phase, such as for example CC-CV charging that starts at 20% SoC and ends at 80% SoC while logging relevant battery data, or CC charging that starts before the IC peak value and ends before reaching the CV phase while logging relevant battery data, and thereafter by cycling the battery under another partial charge phase while logging relevant battery data, and so on.

Alternatively, partial charging curves may for example be provided by using battery data resulting from battery cells that were cycled under the complete CC-CV charging, i.e. from essentially 0 - 100% SoC, but where some part of the charging profiles was subsequently removed manually or by computer during data processing to form synthetic partial charging curves. These synthetic curves will differ from the natural partial charging profiles of real-world battery cells due to the voltage polarization effect and the internal resistance caused by the initial voltage rise, but may nevertheless provide valuable and useful result and insight.

Prior art battery SoH estimators are generally based merely on complete CC-CV charging curves, and this may cause model-plant mismatch when applied based on partial charging curves, and as a consequence expose the prior art battery SoH estimators to a serious pitfall and result in poor performance for vehicle applications. To the best of our knowledge, none of the existing IC/DV feature-based SoH estimators has thoroughly, systematically, and statistically avoided this pitfall.

This is solved at least partly by applying an ensemble of Machine Learning (ML) models in combination with SoH estimation fusion for providing improved battery aging diagnostics.

Specifically, by combining and fusing the SoH estimation result of a plurality of different ML algorithms, the potential poor SoH estimation provided by an individual ML counterpart maybe significantly reduced. The advantages of the combined models over its individual counterparts become even greater when the presumptions for the individual models do not hold strictly for certain cases.

This disclosure describes example embodiments of an efficient, practical, and easy-to-implement method for battery SoH estimation, that may increase the accuracy, in particular with to combining the individual estimations more optimally during the real deployment.

With reference to figure 2, according to some example embodiments, the method for estimation of state of health of a rechargeable battery comprises a first step S100 of obtaining input data of a set of predetermined battery features that jointly indicates State of Health of the battery 5. Thereafter, the method comprises a second step S200 of applying a plurality of machine learning algorithms to conduct state of health estimation of the battery 5, wherein each machine learning algorithm, based on obtained input data from the battery features, calculates an estimation of state of health of the battery 5, as well as quantitative estimation of a confidence interval of the state of health estimation of the battery. Finally, the method comprises a third step S300 of applying a Kalman filter (KF)-based fusion algorithm for combining the state of health estimations from all of said plurality of machine learning algorithms, for providing a fused estimation of state of health of the battery 5.

All these three steps S100-S300 are preferable performed online, i.e. in real-time during actual daily use of the vehicle, such as a driving or parking. The sequence of steps forming the method may be repeated regularly and/or in connection with a certain event, such as in particular a charging event, but also or alternatively during other events, such as during driving, i.e. during discharging events.

In case the battery SoH estimation method is applied at each charging event, the method will generally automatically generate an updated battery SoH estimation after each charging event.

The second step S200 applying a plurality of machine learning algorithms to conduct state of health estimation of the battery may for example include applying two different types of ML algorithms based on obtained input data from the battery features, or three different types of ML algorithms based on obtained input data from the battery features, or four different types of ML algorithms based on obtained input data from the battery features, or five different types of ML algorithms based on obtained input data from the battery features, or more different types of ML algorithms based on obtained input data from the battery features.

In some example embodiments, at least Bayesian ML algorithm and at least one frequentist ML algorithm is applied to calculate two individual battery SoH estimations that are subsequently fused in the Kalman filter based on at least two individual calculated estimation confidence intervals. By using at least one ML algorithm of each type, the risk for systematic errors associated with a certain type of ML algorithm is reduced.

In some example embodiments, at least two Bayesian ML algorithms and two frequentist ML algorithms are applied to develop SoH estimation models, each of which quantitatively calculates an estimation confidence interval.

The present method and system for estimation of state of health of a rechargeable battery may be based on battery feature data from various types of charging scenarios, such as full CC-CV charging from about 0 - 100% SoC, or partial CC-CV charging scenarios, or other types of charging scenarios.

The present method and system for estimation of state of health of a rechargeable battery may thus for example, during a setup phase, define two or more different predetermined charging scenarios, and subsequently train the plurality of machine learning algorithms to estimate the battery SoH for each of the predetermined charging scenarios.

Consequently, during later use of the vehicle, i.e. after leaving the vehicle manufacturing plant and having entered real-world battery usage, a vehicle electronic microcontroller may be configured to, for each new charging event, analysing the new charging event and identifying the predetermined charging scenario from a set of predetermined charging scenarios that is most similar to the new charging event, and thereafter applying a plurality of machine learning algorithms that are trained on said most similar predetermined charging scenario for calculating a set of individual battery SoC estimations, based on battery feature data obtained from said new charging event. Said individual battery SoH estimations are subsequently fused in the Kalman filter as discussed above for calculating a single resulting battery SoH estimation.

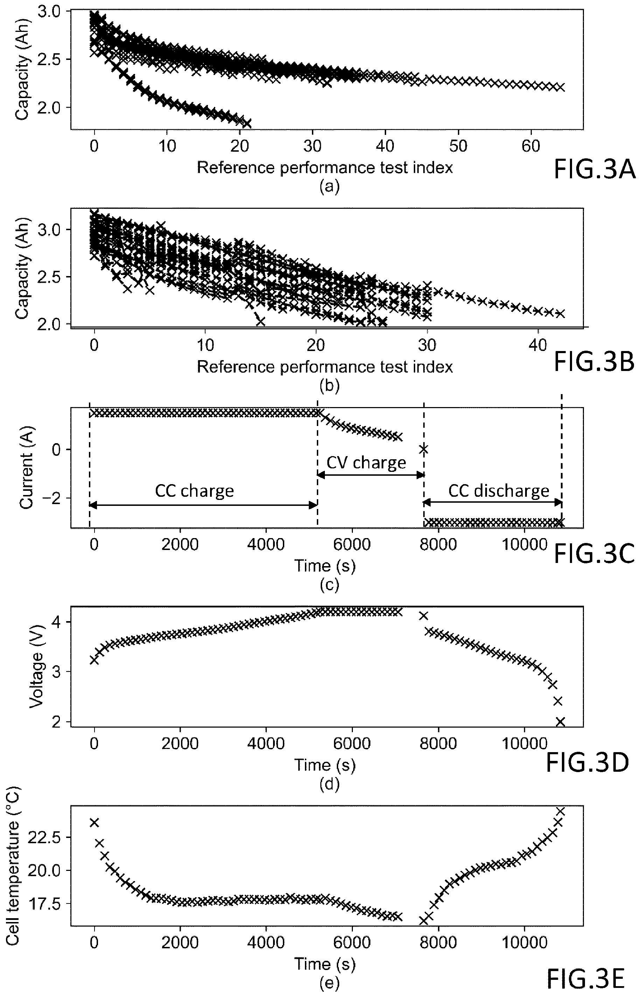

Hereinafter, a specific example embodiment of the method and system for estimation of state of health of a rechargeable battery is described more in detail with reference to figure 3A to figure 16D.

First, all possible charging processes of electric vehicles (EVs) are categorized into a set of different charging scenarios. In this specific example embodiment, six feasible and mutually exclusive scenarios were selected, but the method according to the disclosure is clearly not limited to this specific number of charging scenarios, or even having different charging scenarios at all. For each charging scenario, a set of highly relevant features is extracted. Secondly, two Bayesian ML algorithms and two frequentist ML algorithms are applied to develop battery SoH estimation models, each of which quantitatively calculates an estimation confidence interval. Thirdly, a Kalman filter (KF)-based fusion algorithm is introduced to systematically combine all these battery SoH estimation models. The model fusion can be implemented in real-time with minor extra computation efforts. Relative to individual battery SoH estimation models, the online fusion algorithm achieves highly accurate and robust results along with a significantly tightened confidence interval.

Later on in the text, illustrative results from a large number of batteries with different chemistry verify the efficacy of the method and system according to the disclosure.

Proper dataset selection may help when tackling the problem of battery SoH estimation under arbitrary vehicle operating conditions. In this regard, the dataset for model development and validation should be as close to real-world battery usage as possible. The dataset used herein for verifying the efficacy of the battery SoH estimation model was acquired from Sandia National Laboratories (SNL). The dataset was prepared and analysed in the research paper "Degradation of Commercial Lithium-Ion Cells as a Function of Chemistry and Cycling Conditions" by Y. Preger, H. M. Barkholtz, A. Fresquez, D. L. Campbell, B. W. Juba, J. Roma'n-Kustas, S. R. Ferreira, B. Chalamala, J. and published in Electrochem. Soc. 167 (12) (2020) 120532. doi: 10.1149/1945-7111/abae37. Furthermore, the dataset may for example be acquired via the URL: https://www.batteryarchive.org/study summaries.html

The SNL dataset and underlying experiments were initially conducted to investigate the effect of different stress factors, e.g., the discharge rate, depth of discharge, and environment temperature, on the degradation performance of commercial cells of different types of chemistry. The cells with Nickle Manganese Cobalt (NMC) and Nickle Cobalt Aluminium (NCA) as the positive electrode were selected. The detailed cell specifications are listed in Table 1.

Table 1: Battery cell specifications

| Battery | NMC | NCA |
|---|---|---|
| Manufacture | LG Chem | Panasonic |
| Part number | 18650 HG2 | NCR18650B |
| Nominal capacity (Ah) | 3 | 3.2 |
| Nominal voltage (V) | 3.6 | 3.6 |
| Voltage range (V) | 2-4.2 | 2.5-4.2 |
| Maximum discharge current (A) | 20 | 6 |
| Operating temperature(°C) | -5-50 | 0-45 |

Additionally, Fig. 3A and fig. 3B illustrate the capacity retention trend of the NMC and NCA battery cells, respectively. Since all the cells were charged under 0.5C during the tests. The capacity during the charging phase was accumulated and, the result was used as the ground truth of battery capacity. Fig. 3C, fig. 3D, and fig. 3E exemplify the current, voltage, and temperature curves of a typical charge and discharge cycle, respectively. Specifically, figure 3A shows the capacity degradation curve of 31 NMC cells and figure 3B represents the capacity degradation curve of 24 NCA cells. Figures 3C-E exemplify a typical cycling profile of the studied battery. The test campaign setups are shown in Table 2. As can be seen, the cells were exposed to different partial charging levels and cycled under three different environment temperatures.

Table 2: Battery cell test campaign

| Depth of discharge | Temperature | Discharge rate |
|---|---|---|
| 20%-80% | 25°C | 0.5C |
| 40%-60% | 25°C | 0.5C |
| 0%-100% | 15°C | 1C |
| | 15°C | 2C |
| | 15°C | 3C |
| | 25°C | 0.5C |
| | 25°C | 1C |
| | 25°C | 2C |
| | 25°C | 3C |
| | 35°C | 1C |
| | 35°C | 2C |
| | 35°C | 3C |

As stated earlier, nowadays, the CC-CV charging strategy is commonly used by automotive companies. CC-CV charging strategy is schematically illustrated in figure 3C, wherein the first charging phase is performed with CC charging, i.e. applying a constant charging current while battery voltage is increasing. The second charging phase is performed with CV charging, i.e. constant voltage while battery charging current is slowly decreasing. The third phase is a CC discharge phase, i.e. a constant current discharge phase while the battery voltage is slowly decreasing again.

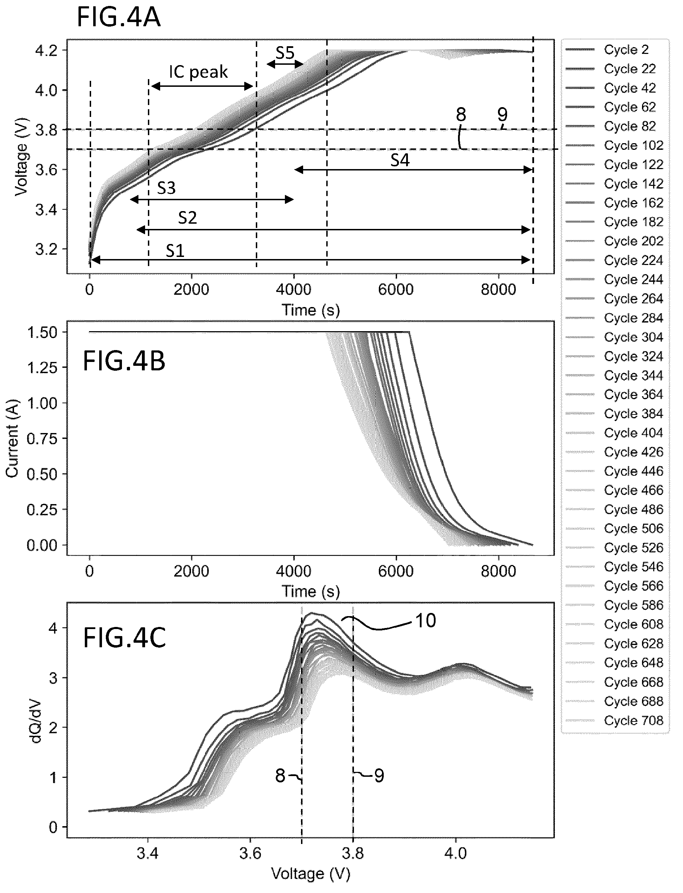

All measurements of figures 3A-12D were generated at a sampling rate of 1 Hz. When the charging realization is CC-CV, the raw current and voltage data were used to extract smooth and consistent IC curves. The charging current and voltage profiles over different cycles of one typical battery under study are shown in Fig. 4a and fig. 4b, respectively. The corresponding IC curves are illustrated in Fig. 4c.

Unlike cycling battery cells in the laboratory, with repeatable profiles under a controlled environment, practical battery usage is highly dynamic with frequent changes in the operating conditions. The usage profile can become even more complex when an EV is shared by different drivers, and, in general, the driving profiles are also unpredictable. Additionally, seasonal and local temperature variations will have a large impact on the battery's performance and internal aging state. Compared to the discharging profiles, charging profiles are easy to control, and the same control law is often repeatedly used. Consequently, in this example embodiment, only the charging curves are used to estimate the capacity values. The assumption commonly applied in laboratory tests that all charging cycles start from the same initial SoC level and are contained at a fixed ambient temperature are here eliminated. In other words, the method and system according to this disclosure are not limited to rigorously repetitive CC-CV charging cycles. Instead, the method and system according to this disclosure is configured to provide a reliable battery SoH estimation irrespective whether arbitrary CC-CV charging profiles or any other charging strategies are applied.

Based on the above discussion, all the existing charging profiles are categorized into five different and mutually exclusive scenarios S1-S5, illustrated in Fig. 4a.

As illustrated in figures 4C, the IC peak region is located within a lower voltage level 8 of about 3.7 V and an upper voltage level 9 of about 3.8 V. These to voltage levels are included also in figure 4A, and the IC peak range is defined in figure 4A as the range extending from a crossing between the lower voltage level 8 and the charging voltage profile of the 708 charging cycle, to a crossing between the upper voltage level 9 and the charging voltage profile of the second charging cycle.

In this example embodiment, the five different charging scenarios S1-S5 are:

Charging scenario S1: Complete CC-CV charging from 0% SoC to 100% SoC.

Charging scenario S2: Partial CC-CV charging that starts before the IC peak value 10, see figure 4C, and ends with the complete CV phase (see Fig. 4a).

Charging scenario S3: Partial CC charging that starts before the IC peak value 10 and ends without the CV phase.

Charging scenario S4: Partial CC-CV charging that starts after the IC peak value 10 and ends with the complete CV phase.

Charging scenario S5: CC charging that starts after the IC peak value 10 and ends without the CV phase.

Note that temperature is not mentioned in any of the above scenarios, implying that common constraints imposed on the ambient temperature for SoH estimator design are removed.

For ML algorithms to work accurately and efficiently, it is beneficial to select relevant and informative battery features. This process of selecting suitable battery features is also known as feature construction. At the same time, for the algorithms to take effect, the chosen features must be available under practical charging cycles. For the defined charging scenarios, different features will be added to the feature pool according to their availability.

In some example embodiments, specific voltage window-related features may be used as battery features. The voltage and current curves during the charging phase will gradually change as the battery degrades, as shown in Fig 4A - 4B, wherein fig. 4A shows the change of the voltage curve along with an illustration of different charging scenarios, fig. 4B represents the change of the current curve, and fig. 4C shows the change of the IC curve.

A predefined sub-range of the raw charging voltage data may thus be selected as the base to construct features. According to a first example, the time interval between a predefined voltage window may be chosen as a battery feature since the aged cell will gradually need less time for charging than the newer cell, as can be seen in Fig. 2A.

According to a second example, the signal strength over time, often regarded as the energy of the signal, can also be used as a battery feature, wherein energy of the signal can be calculated as

$$E = \int_0^\infty s(t)^2 dt \qquad (1)$$

where s(t) is the signal.

According to a third example, the area under the current and voltage curves could be used as a battery feature, because this area also represent the aging state of the batteries and may be used to estimate battery capacity, i.e. battery SoH.

According to a fourth example, by observing the voltage curve change over battery lifetime, it is noticed that the voltage curve in the CC phase becomes steeper as the battery ages. Consequently, the slope of the voltage curve may be selected as a battery feature candidate.

Similarly, the slope of the current curve in the CV phase could serve as a battery feature if there is a CV phase in the charging profile, i.e. charging scenario.

In some example embodiments, IC curve-related features may be used as battery features. IC (incremental capacity) is defined as the ratio between the change of the charging capacity and the corresponding voltage change in a predefined time interval. As a promising way for non-destructive battery aging mechanism identification and battery characteristics method, IC analysis is also a source to extract informative health indicators since the underlying pattern of the IC curves changes during battery degradation.

However, the specified time interval, the division calculation, and the measurement noise from current and voltage sensors will greatly impact the final IC curve. To make the obtained IC curves over the battery's entire lifetime comparable, a time interval of a certain length, such as for example ten seconds, may be adopted, and a Kalman Filter (KF) or the like may be applied to smooth the calculated IC curve.

It is noteworthy that when applying IC-related features for battery capacity estimation in real-world applications, the initial SoC level, and the cell temperature can dramatically change the character of the constructed IC curve due to the cell polarization and internal resistance changes. To cope with such changing effects, it is possible to include the initial charging SoC and/or the charging temperature-related features into the battery feature pool, such that the ML algorithms can take initial SoC level and/or battery cell temperature into account when estimating battery SoH.

According to some example embodiments, for battery features extracted from the IC curve, the peak value [dQ/dV] and its corresponding voltage level or voltage interval may be chosen, since their changes during the battery aging process are quite prominent, as illustrated in Fig. 4C.

Battery feature engineering may be performed in various ways. When feature engineering involves a manual feature selection process to incorporate domain knowledge, there is a risk of selecting uncorrelated or redundant features into the battery feature pool. A correlation analysis may thus be conducted to rank the battery features according to their correlation with the target variable, i.e., the capacity value. After that, a feature check-and-control scheme may be applied to ensure that the redundant features are not selected for training ML algorithms. By doing so, a good trade-off between model accuracy and computational complexity may be expected.

The correlation analysis may be for example involve performing a Spearman correlation analysis, or another type of correlation analysis.

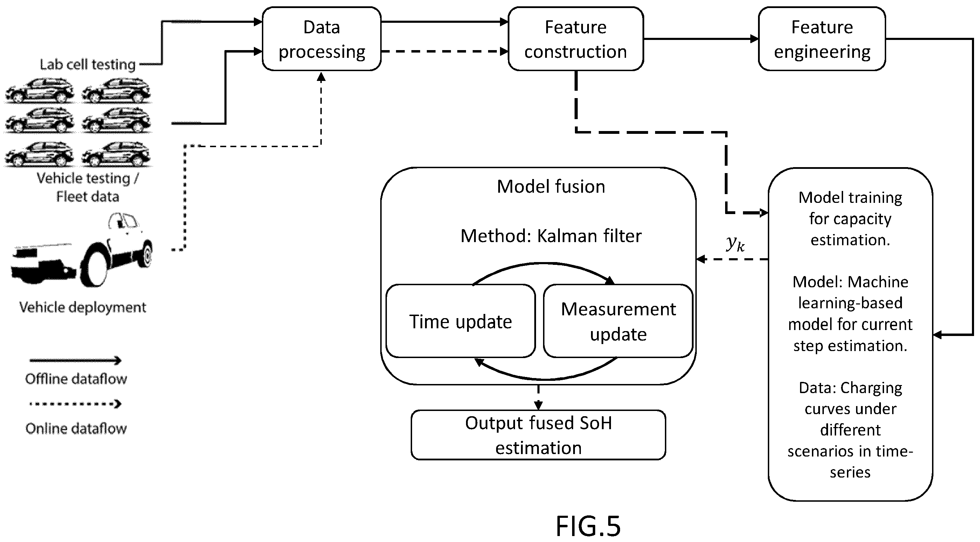

The estimator design may be implemented in various ways. In one example, the proposed estimator contains the capacity estimation model developed from time-series data, wherein the KF is adopted to optimally fuse all the model results from the plurality of machine learning models and to provide the final capacity estimate. The SoH estimation flowchart according to this example embodiment is illustrated in Fig. 5.

In this example embodiment, three evaluation matrices are applied to quantify the estimation performance, namely the mean absolute percentage error (MAPE), the root mean square percentage error (RMSPE), and the 95% percentile confidence interval of the estimation result. They are mathematically defined as

$$MAPE = \frac{1}{N}\sum_{i=1}^{N}\frac{|Q_i - \hat{Q}_i|}{Q_i} \qquad (2)$$

$$RMSPE = \sqrt{\frac{1}{N}\sum_{i=1}^{N}\left(\frac{|Q_i - \hat{Q}_i|}{Q_i}\right)^2} \qquad (3)$$

$$CI = \hat{Q}_i \pm 2 \times \sigma\left(\hat{Q}_i\right) \qquad (4)$$

where $Q_i$ is the measured capacity value, $\hat{Q}_i$ is the estimated capacity value, N is the total sample number in the test set, and CI is a 95.4% probability for Gaussian distribution with the covariance denoted by $\sigma(\hat{Q}_i)$.

As the estimation result can imply a decision, corrective actions or carry forward to the prognostic step, the estimation uncertainty evaluation becomes indispensable.

In the example embodiment, four ML algorithms, two of which are probabilistic and two frequentist-based, are selected to develop models for the capacity estimation. All of them are able to quantitatively propagate their estimation uncertainty to provide a confidence interval for their results. Henceforth, the ML algorithm output, i.e., the battery capacity Q, will be referred to as y, and the corresponding features will be represented by x. A random-search hyperparameter tuning is applied together with 5-fold cross-validation to find the optimal hyperparameters for each ML algorithm.

The first ML algorithm may for example be Gaussian process regression (GPR). As a non-parametric and probabilistic model, GPR attempts to learn a posterior distribution rather than a single value of the model parameter.

Furthermore, instead of treating the model parameters as random variables, as in Bayesian ridge regression (BRR), GPR treats the model function f (x) as a Gaussian process and uses it to compute the posterior probability P( f (x)|y). Here, f (x) is defined as

$$f(x) \sim GP(\mu(x), \kappa(x, x')),$$

where x and x' are two arbitrary feature samples, $\mu(x)$ is the mean function, and $\kappa(x, x')$ is the covariance function or, equivalently, the kernel function. Intuitively, the kernel function determines how strong the correlation is between the two samples, x and x'. Given a series of training pairs {X, Y} with X = {x1, x2, $\cdots$, xn} and Y = {y1, y2, $\cdots$, yn}, GPR predicts a new test sample x* by conditioning f (x) on the training data to find the posterior prediction distribution. GPR has high prediction accuracy, even though there is only a relatively small dataset, and is able to quantify the uncertainty of predictions. These merits make it a popular method for battery diagnostics.

However, with a large dataset or high feature dimensions, GPR becomes prohibitively computationally expensive due to matrix inversions.

The second ML algorithm may for example be Bayesian ridge regression (BRR). Applying a Bayesian approach to a linear regression model leads to the so-called BRR. Instead of treating the coefficient $\theta$ as a single variable, BRR assumes $\theta$ as a spherical Gaussian distribution, defined as P($\theta$) = N($\theta$; 0, $\Sigma0$), having zero mean and the covariance $\Sigma0$. Here, $\Sigma0 = I\alpha$ is chosen to simplify the calculation, where I is the identity matrix and $\alpha$ is a positive hyperparameter. $\beta$ is defined as the noise variance of the output y and can be viewed as a regularization parameter. Here, $\alpha$ and $\beta$ may be assumed to be uninformative priors subject to gamma distributions. By maximizing the marginal likelihood, these two parameters can be optimized during training. With $\alpha$, $\beta$, and the conjugate prior, the posterior can be explicitly calculated. The simplicity in training and testing and the good interpretability of the estimation result make it a suitable ML algorithm. However, the linear assumption may limit its applicability, especially for complex and nonlinear systems.

The third ML algorithm may for example be Random forest regression (RFR). RFR consists of a collection of different decision trees and can achieve a good bias-variance trade-off by aggregating each tree's output. Through bootstrap replicates that are randomly selected with replication of a subset of the training dataset and features to each individual tree, the infinitesimal jack-knife variance estimation method may be adapted to quantify the estimation confidence interval of the RFR result.

The fourth ML algorithm may for example be a Deep ensemble neural network (DeNN). Deep neural networks (DNN) have recently gained great interest from both academia and industry due to their impressive performance in pattern recognition and trend identification on a wide spectrum of dynamic and complex tasks. An ensemble-based method may be adopted to combine the results of each DNN model and quantify the estimation uncertainty. The final layer may be constructed with two outputs, one being the predicted mean value $\mu(x)$ and the other being the predicted variance $\sigma(x)^2$. Furthermore, the negative log-likelihood function may be selected as the loss function.

The capacity estimation models are of course not limited to the above-described example, but may alternatively include more or less ML algorithms, and/or other types of ML algorithms. For example, the capacity estimation models may include a machine learning algorithm of the support vector regression type, which is a frequentist ML algorithm.

According to a further example embodiment, the capacity estimation models may include a machine learning algorithm of the Linear regression type, which is a frequentist ML algorithm.

According to a further example embodiment, the capacity estimation models may include a machine learning algorithm of the Adaboost type, which is a frequentist ML algorithm.

According to a further example embodiment, the capacity estimation models may include a machine learning algorithm of the Relevant vector regression type, which is a Bayesian ML algorithm.

For a given battery charging profile, the predefined scenarios S1-S5 may not be appropriate for various reasons. For example, predefined scenarios S1-S5 are all associated with CC-CV changing, so when the charging scenario is of a different kind, such as for example multistage CC charging, pulse charging, dynamic charging, or the like, charging scenarios S1-S5 are suitable. The same applies when the given battery charging profile corresponds to abnormal usage behaviour (e.g., extremely shallow discharge/charge), data corruption, communication delay/faults, etc. Under such circumstances, the selected features cannot be extracted using any of charging scenarios S1-S5, thereby rendering all the ML models discussed above infeasible.

Therefore, the method and system may include a further category, i.e. a sixth charging scenario S6, which covers all the remaining scenarios are not covered by S1-S5. As a result, all the existing charging profiles are categorized into six different and mutually exclusive scenarios S1-S6.

Specifically, the method and system for state of health estimation of a rechargeable battery according to the present disclosure may be complemented with a histogram data-based model for capacity prediction that is triggered as soon as the given battery charging profile does not fall under any of the charging scenarios covered by S1-S5.

The histogram data-based model for capacity prediction enables the capacity monitoring task at the current time step k may be treated as a prediction problem instead of estimation, using historical capacity estimates up to k - 1 and features extracted from usage data.

In other words, for enabling online prediction of battery aging trajectory and lifetime with any format of raw data collected under various operating conditions, a histogram data-based machine learning framework may be implemented. This framework fits well the capacity prediction task and is therefore implemented recursively whenever charging scenario S6 is triggered.

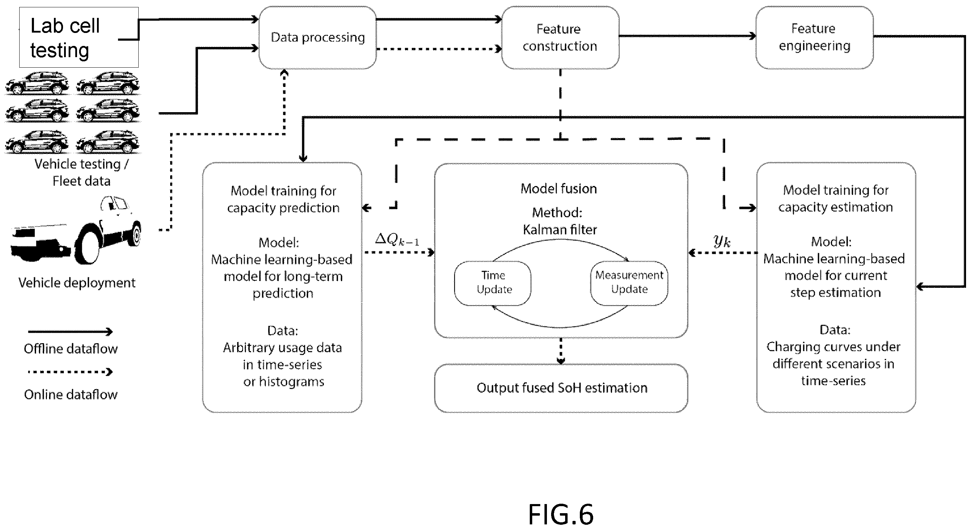

A schematic layout and flowchart of an battery SoH estimator design including two types of internal models, with one being the capacity estimation model developed from time-series data and the other being the capacity prediction model developed from histogram-based data, is schematically showed in figure 6. Then, the KF is adopted to optimally fuse all the model results and provide the final capacity estimate.

The end-user usage data, e.g., the accumulated discharge/charge energy throughput, discharge range, cell temperature, charging current, discharging current, voltage, vehicle parking time and state of charge, no matter in time series or histograms of any dimension, are transformed into one-dimensional (1D) histogram data. Then, a set of statistic properties of the constructed 1D histograms are extracted and used as initial feature candidates.

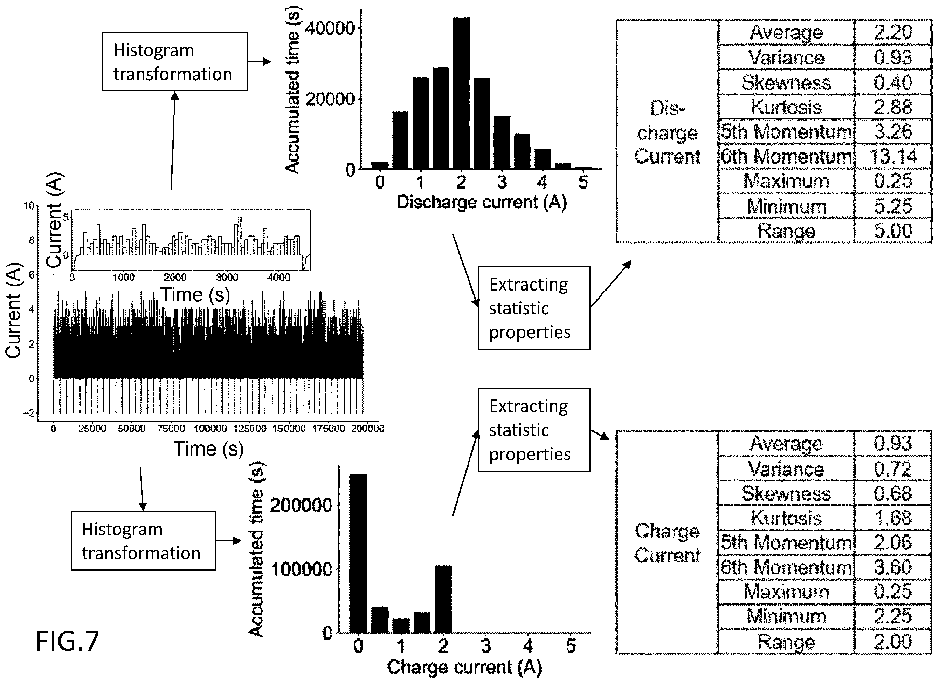

Specifically, an example embodiment of flowchart for performing the feature construction based on histogram-based data is schematically illustrated in figure 7, which starts with a times series of end-user usage data in form of charging and discharging current. A histogram transformation is then performed for transforming this data into one-dimensional (1D) histogram data. In figure 7, discharge current and charge current are displayed in separate one-dimensional (1D) histogram charts. Then, a set of statistic properties of the constructed 1D histograms are extracted and used as initial feature candidates. In figure 7, a set of statistic properties is extracted for each of the one-dimensional (1D) discharge current histogram chart, and one-dimensional (1D) charge current histogram chart.

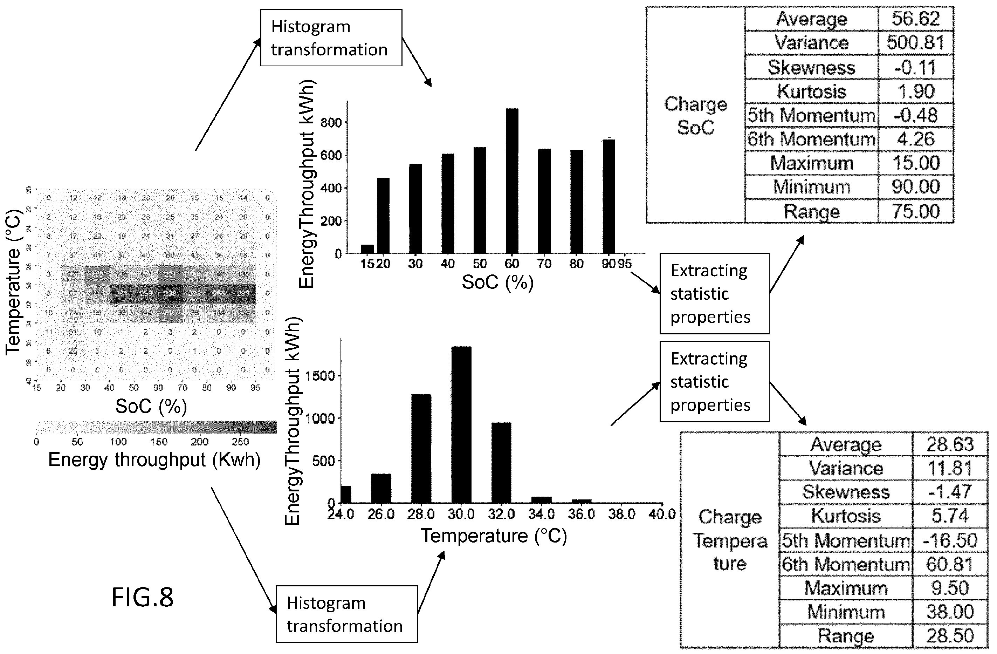

The user data may be any format, and does not need to be in times series. For example, figure 8 schematically illustrates the same extraction of a set of statistic properties as described with reference to figure 7, but here starting with end-user usage data in form of a 2D histogram, that undergoes a histogram transformation for transforming the data into one-dimensional (1D) histogram data, and subsequently extracting a set of statistic properties of the constructed 1D histograms for use as initial feature candidates.

Thereafter, feature engineering may be performed for identifying a set of finally selected battery features. The feature engineering may for example involve a correlation analysis for determining the correlation between each feature and the system output, i.e., the change of battery capacity at a defined time interval and the correlation among different features. Specifically, the Spearman correlation analysis may be applied to measure the strength and direction of monotonic association between two variables. The Spearman correlation analysis is adopted to all features in the pool relative to the capacity change for that identifying and discarding the redundant battery features.

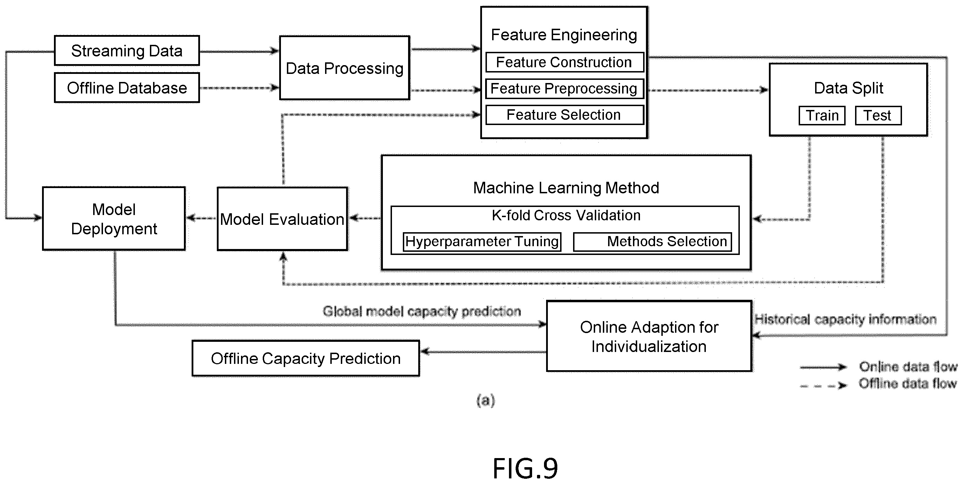

The remaining battery features, i.e. the selected features, denoted by $x_{hd}$, are employed to learn battery aging behaviour. Specifically, the task of battery ageing prognosis is here formulated as a regression problem within the framework of supervised machine learning. One example of an overall pipeline to accomplish the task is summarised in figure 9, which includes an offline path for a global model development and an online path for model adaptation along with the streaming data.

The global model is first developed offline from N labelled input-output pairs in the available dataset, generated from a statistically significant number of batteries

$$\Delta \hat{Q}n = f_{\text{global}}(x_{hd,n}), \ n \in \{1, \cdots, N\} \tag{5}$$

where $\Delta \hat{Q}n$ represents the capacity loss between two consecutive samples for any battery in the dataset.

The global models are thus developed only from the offline training dataset involving a number of battery cells of the same type. From these cells, each model essentially tries to learn the averaged ageing behaviour in response to the selected features. The model development process includes hyperparameter tuning, method selection, model evaluation, and online deployment.

For the offline regression problem a suitable machine learning algorithm is employed to develop the function $f_{\text{global}}()$. The machine learning algorithm may for example be Support Vector Regression (SVR), Random Forest Regression (RFR), Gaussian Process Regression (GPR), or Artificial Neural Network (ANN).

After obtaining a reasonable global model in (5), the second step is to adapt it online to any considered individual battery, indexed by $m \in \{1, \cdots, M\}$. This is achieved by expressing the degradation of cell m as $\lambda_{m,k} f_{\text{global}(Xhd,m,t)}$, where $\lambda_{m,k}$ is a correction coefficient. With the historical capacity estimation values (e.g., obtained when any scenario of S1-S5 is active) saved in the BMS memory, a cell individualized model for the faded capacity of battery m, is then determined by making a trade-off between the cell corrected model, i.e., $\lambda^*_{m,k} f_{\text{global}}(x_{hd,m,t})$ and the global model, i.e., $f_{\text{global}}(x_{hd,m,t})$, where $\lambda^*_{m,k}$ is optimized online to get the best possible fit to historical data, i.e., $\{\hat{Q}m, 1 \cdots, \Delta \hat{Q} m, k-1\}$. The capacity fade from step k - 1 to any future time step t ≥ k is then expressed as

$$\Delta \hat{Q}_{m,t} = (1 - w^*_{k,t})\, f_{global}(x_{hd,m,t}) + w^*_{k,t}\, \lambda^*_{m,k}\, f_{global}(x_{hd,m,t}), \tag{6}$$

where $w^*_{k-1}$ is a weight coefficient calculated offline to optimally trade-off between the global estimate $f_{global}(x_{hd,m,t})$ and the individually corrected estimate $\lambda^*_{m,k}\, f_{global}(x_{hd,m,t})$. By assigning t to k + 1 in equation (6) above, the following one-step capacity prediction model is obtained,

$$\Delta \hat{Q}_k = (1 - w^*_{k-1,k})\, f_{global}(x_{hd,k}) + w^*_{k-1,k}\, \lambda^*_{k-1}\, f_{global}(x_{hd,k}), \tag{7}$$

$$\hat{Q}_k = \hat{Q}_{k-1} + \Delta \hat{Q}_k, \tag{8}$$

where the subscript m is dropped for any arbitrary battery during online deployment.

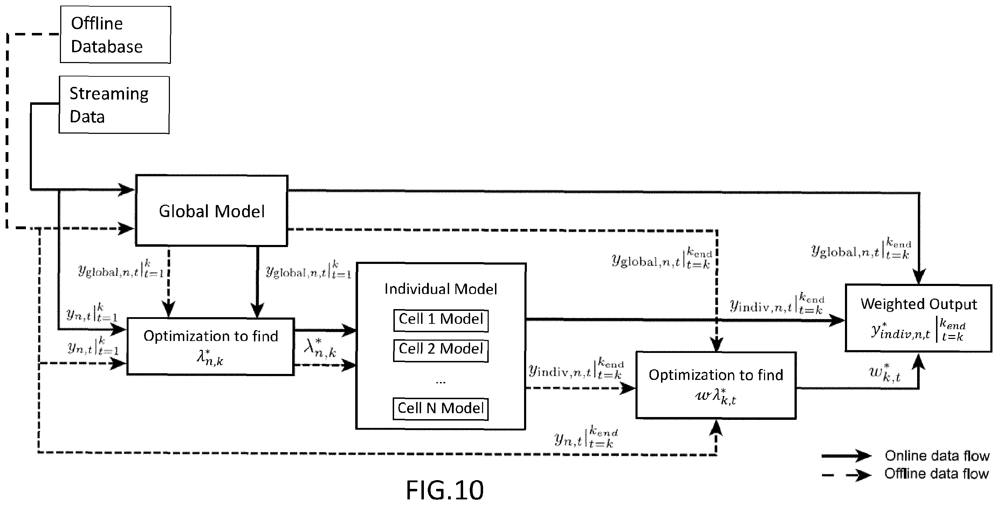

The complete workflow is schematically illustrated in Fig. 10, which shows the workflow of the proposed online adaptation algorithm for battery capacity prediction. Overall, this proposed adaptation algorithm operates in a closed loop that not only takes into account the ageing characteristics of battery cells in the database but also explicitly includes the considered cell's property and operating conditions. As a result, issues like cell variations, measurement noise, and disturbances are systematically handled

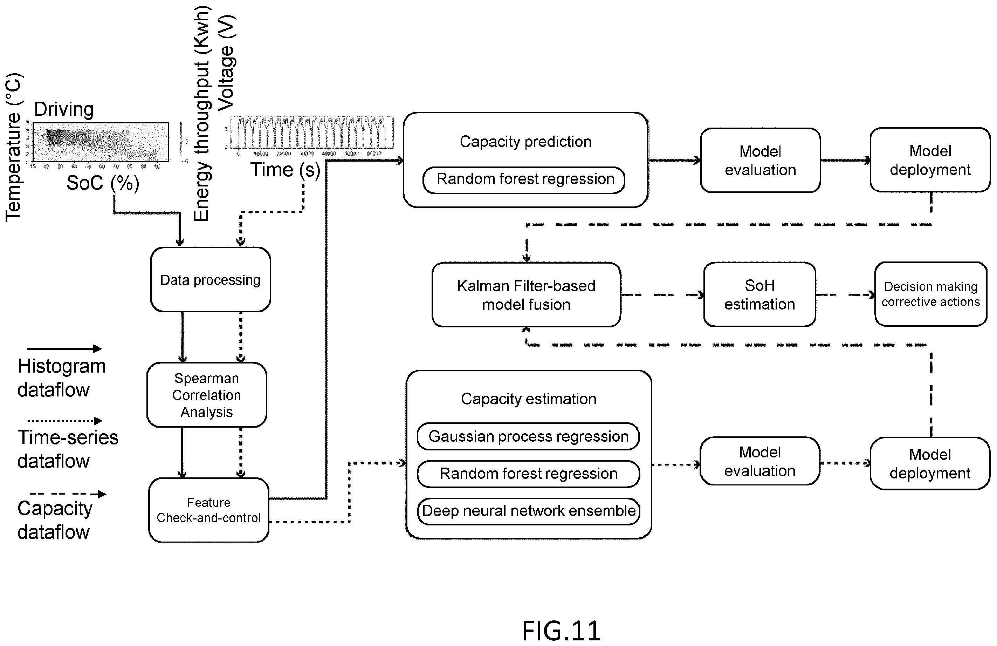

The ML models for providing an SoH estimate in connection with any of the charging scenarios S1-S5 discussed above have their advantages and disadvantages. The best performing algorithm may vary depending on different datasets and operating conditions. Fusing the results of all algorithms may therefore give a more accurate and reliable estimation of battery capacity. A Kalman Filter (KF) is used to optimally combine the estimation models and the prediction model described above. The overall capacity estimation flowchart is shown in Fig. 11.

By defining the process noise as w and the measurement noise as v, the dynamic system of battery capacity is formulated as

$$Q_k = Q_{k-1} + \Delta Q_{k-1} + w_{k-1}, \tag{9}$$

$$y_k = CQ_k + v_k. \tag{10}$$

When the true capacity is not measured during operations, the system output y is a vector of the estimation results from the ML models described above and is defined by

$$y = \hat{Q}_{GPR}\ \hat{Q}_{BRR}\ \hat{Q}_{RFR}\ \hat{Q}_{DeNN}{}^{\mathsf{T}} \tag{11}$$

implying that $C = {}_{1\,1\,1\,1}{}^{\mathsf{T}}$.

$\Sigma_w$ and $\Sigma_v$ are covariances of the process noise and the measurement noise, respectively. The covariance of the measurement noise is composed of the uncertainty quantifications of the estimates using four ML models.

Assumption 1: The noise w and v are uncorrelated.

Justification 1: The estimation model is developed from time-series features using the probabilistic or frequentist-based ML algorithms. In contrast, the prediction model is obtained from usage-related histogram-based features using RFR. Therefore, with different inputs, ML models, and training processes, the corresponding noise terms w and v are naturally uncorrelated.

Assumption 2: w and v are zero-mean, white, and Gaussian noise.

Justification 2: All the estimations conducted to obtain the system output y are independent and random, so as the process to obtain the system input $\Delta Q_k$. Therefore, it can be assumed that $v_k$ and $w_k$ are at least close to white noise.

Based on the nominal model of the dynamic system (9)-(10), a standard KF is designed, i.e.,

$$\hat{Q}_k^- = \hat{Q}_{k-1}^+ + \Delta Q_{k-1}, \tag{12}$$

$$P_k^- = P_{k-1}^+ + \sum{}_{w,k}, \tag{13}$$

$$K_k = P_k^- P_k^T \left(C_k P_k - C_k^T + \sum{}_{w,k}\right)^{-1}, \tag{14}$$

$$\hat{Q}_k^+ = \hat{Q}_k^- + K_k\left(y_k - C_k\hat{Q}_k^-\right), \tag{15}$$

$$P_k^+ = (\mathcal{I} - K_k C_k)P_k^-. \tag{16}$$

where P is the state covariance matrix, the superscripts - and + signify the prior and posterior, respectively, and $K_k$ is the Kalman gain.

Although each of the used estimation and prediction models can deliver an estimate of the capacity, based on Assumptions 1 and 2, the KF fuses each model's estimates optimally, resulting in increased estimation accuracy and robustness to noise.

During online deployment, the ground truth of battery capacity is seldom available from today's BMS. Then, the KF will, on most occasions, work as an open-loop filter to fuse the estimation results, i.e., yk defined in (11), and the prediction result Q^-k according to their uncertainties.

Random search hyperparameter tuning was adopted for all the employed ML algorithms, and the corresponding hyperparameter range is reported in Table 3.

Table 3: Hyperparameter value range used in random search hyperparameter tuning.

| GPR | Kernel function: RBF kernel, 2/3 Mate'rn kernel, 2/5 Mate'rn kernel, rational quadratic kernel, periodic kernel, and the dot product kernel |
|---|---|
| BRR | $\alpha_1$: [$10^{-6}$, $10^{-3}$]<br>$\alpha_2$: [$10^{-6}$, $10^{-3}$]<br>$\beta_1$: [$10^{-6}$, $10^{-3}$]<br>$\beta_2$: [$10^{-6}$, $10^{-3}$] |
| RFR | Maximum features: [3, 5]<br>Maximum tree depth: [3, 10]<br>Maximum sample split: [3, 9]<br>Maximum sample leaf: [5, 15] |
| DeNN | Hidden unit number: [8, 32]<br>Drop out rate: [0.05, 0.1]<br>Learning rate: [$10^{-4}$, $10^{-1}$] |

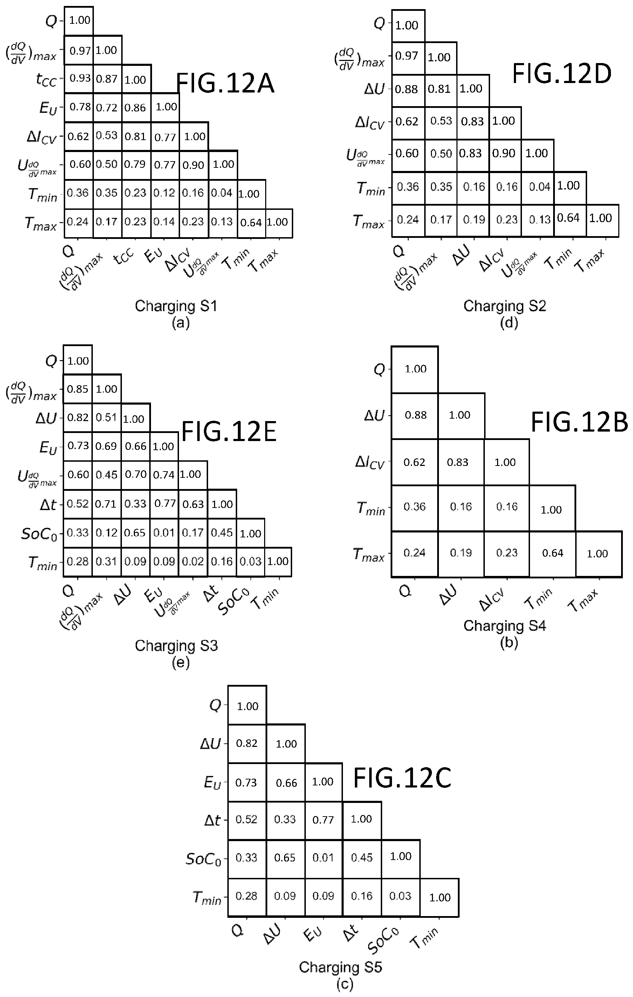

According to the feature selection and engineering procedure described above, the selected features for each charging scenario of the NMC cells are shown in Fig. 12A-12E. Noticeably, when the IC peak value, denoted as $\left(\frac{dQ}{dV}\right)_{max}$, exists in any given charging profile, it is always selected and ranked the highest, as seen for S1, S2, and S3. This means $\left(\frac{dQ}{dV}\right)_{max}$ is the most representative feature among others for the cell aging state. This finding is in line with the previous ICA studies that demonstrated $\left(\frac{dQ}{dV}\right)_{max}$ being a good indicator for battery health diagnostic. Another finding is that when partial charging profiles are used, the initial SoC level is selected as one of the critical features (see the sub-figures for S3 and S5). This is expected since varying the initial SoC dramatically changes the corresponding voltage behaviour because of the polarization effect, even if the batteries experience the same current and operating temperature. It also verifies the aforementioned argument about maintaining the practicability of SoH estimators developed upon partial charging profiles. Temperature-related features are also selected, and they are heavily overlapped among different charging scenarios. This result echoes the fact that temperature is an important stress factor for battery degradation.

Sorting from S1 to S6, the available charging profiles become narrower, and correspondingly, the available features in the pool satisfying our specified selection criteria become less, implying a harsher situation for the ML models to learn battery characteristics.

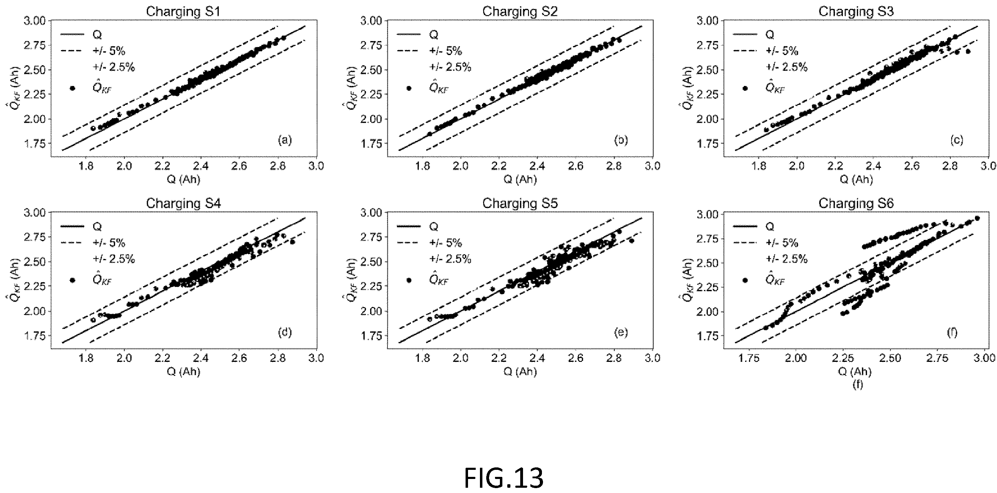

To examine the efficacy of the developed models, their performance were first under lab tests demonstrated for each charging scenario, i.e., applying them to the data where the cells have been receiving the same charging scenario throughout their entire lifetime. The partition of training and test datasets is different for the six considered charging scenarios. For example, for S1, partial charging data cannot be used to train the ML models. Specifically, figure 13 shows the capacity estimation results for the NMC-type battery under different charging scenarios, and table 4 shows the results of different SoH estimation algorithms for NMC batteries under charging scenarios S1-S6.

Table 4

| Algorith ms | S1 | | S2 | | S3 | | S4 | | S5 | | S6 | |
|---|---|---|---|---|---|---|---|---|---|---|---|---|
| | MAPE | RMSPE | MAPE | RMSPE | MAPE | RMSPE | MAPE | RMSPE | MAPE | RMSPE | MAPE | RMSPE |
| GPR | 0.693 | 1.073 | 0.887 | 1.323 | 0.915 | 1.491 | **1.532** | **1.999** | 2.110 | 2.757 | - | - |
| BRR | 0.772 | 1.182 | 0.799 | 1.009 | 1.025 | 1.527 | 1.984 | 2.598 | 2.270 | 2.910 | - | - |
| RFR | 0.632 | **0.857** | 0.874 | 1.202 | 0.877 | 1.231 | 1.817 | 2.312 | **1.725** | 2.262 | - | - |
| DeNN | 0.919 | 1.418 | 0.816 | 1.114 | 1.027 | 1.471 | 1.576 | 2.132 | 1.860 | 2.334 | - | - |
| KF | **0.629** | 0.861 | **0.714** | **0.880** | **0.751** | **1.178** | 1.662 | 2.110 | 1.731 | **2.229** | 3.899 | 5.611 |

The estimation errors of different SoH estimation algorithms are first quantitatively studied for NMC-type batteries, with the results listed in Table 4. It can be seen that from S1 to S5, all the estimation ML models derived, and the KF, achieve reasonable estimates, with a MAPE of 0.629% for the best case and 2.27% for the worst case. When the batteries are operated under S6 over their entire lifespan, albeit a very rare case for EV applications, the proposed model fusion method can estimate the capacity trajectory at a MAPE of 3.899%. It is worth mentioning that under S6, the estimation models (10) derived by GPR, BRR, RFR, and DeNN are infeasible, and then the capacity estimation can only be performed by the prediction model (9). The relatively poor estimation result is simply attributed to the fact that a very small and sparse set of training data has been used. From the table, it can also be observed that for the six scenarios, when there are more qualified features in the pool, the estimation tends to become more accurate. This means one should always conduct the capacity estimation under the feature-richest scenario.

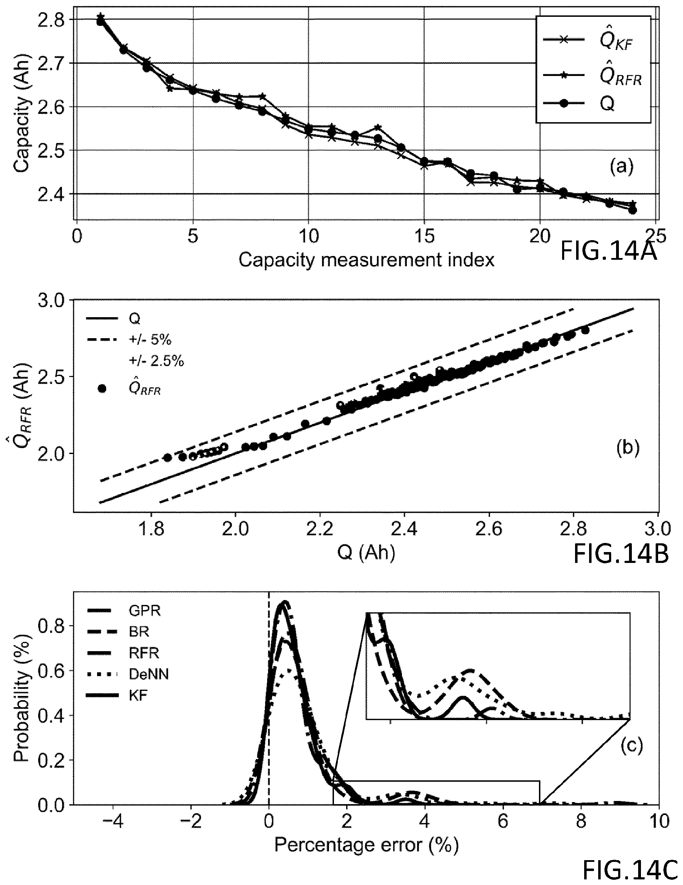

For example, figure 14A-14C show the estimation results of a randomly selected NMC-type cell under scenario S1.

The results in Table 4 also verify the superiority of the proposed KF-based fusion method - it generally performs better than or as well as the best-performing individual model. To look more closely, Fig. 13 illustrates that under the first five scenarios, the KF rarely exceeds ±5% error, while under S1-2, all the estimation results are within ±2.5% error; From the estimated capacity trajectories of Fig. 14A-14C instantiated for a randomly selected cell under S1, KF follows the measured capacity better than the best individual ML model, i.e., RFR in this case. The obtained numerical results are, to a large extent, consistent with Remark 1. However, the global optimality is not achieved by the KF with the employed battery dataset. This is because the zero-mean part for the measurement noise v in Assumption 2 does not hold. As demonstrated in Fig. 14C, the mean values slightly deviate from zero and are located in a range of [0.4%, 0.6%] for the four estimation models in (10). The remaining part of Assumption 2 is valid, as both v and w have a (nearly) Gaussian distribution, respectively.

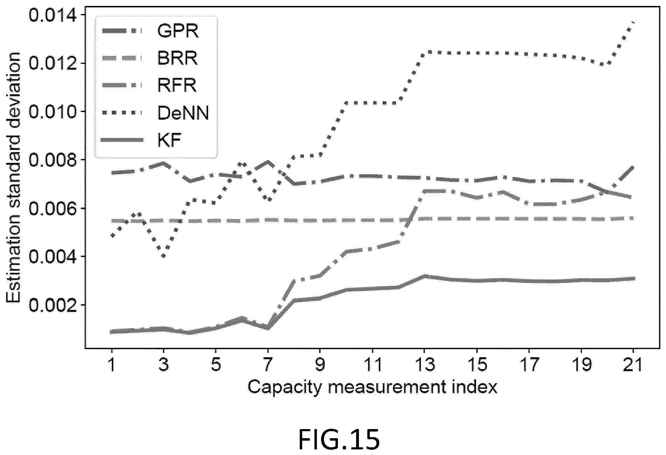

All the models developed here can provide a 95 percentile estimation confidence interval, therefore providing valuable information for predictive battery maintenance and usage optimization. Moreover, by fusing the estimation results from all the individual models using KF, the confidence interval is considerably tightened, in other words reducing the uncertainty significantly. Fig. 15 shows the standard deviation of the results from the best model, the worst model, and the model fusion for a randomly selected cell. Figure 15 thus shows that the standard deviation of the estimates from KF, $\sigma_{KF}$, is always smaller than that of any individual model. After the seventh index, the standard deviations of the best individual model and the worst model are 2 and 5 times larger than $\sigma_{KF}$, respectively.

The present disclosure is specifically arranged for providing reliable SoH estimation results during vehicle daily usage. In practice, it is rather rare that a battery only undergoes one charging profile during its whole lifetime. Therefore, it is worthwhile to explore the estimation performance when various charging profiles are exhibited on one specific battery. In the present test of the method, no cell in the database was cycled using multiple charging profiles. Therefore, the test result from the cells experienced with the full CC-CV charging are used, and then their profiles are cut to mimic partial charging. By doing so, the effectiveness of different models under practical charging cases can be demonstrated and compared. Indeed, the corresponding results will not reflect the real-world usage precisely, but it enables testing of the present SoH estimation method, and if the method is implemented in real-world usage in a vehicle, real partial charging profiles will of course be available.

Table 5: SoH estimation results under various practical charging scenarios

| Algorithms | Protocol 1: Periodically repeat {S1, · · ·, S5, S6} | |
| --- | --- | --- |
| | MAPE | RMSPE |
| GPR | 1.337 | 2.408 |
| BR | 1.373 | 1.847 |
| RFR | 1.314 | 1.706 |
| DeNN | 1.092 | 1.58 |
| KF | **0.631** | **0.813** |
| | Protocol 2: Periodically repeat {S1, · · ·, S5, S6, S6} | |
| GPR | 1.486 | 2.278 |
| BR | 1.723 | 2.245 |
| RFR | 1.710 | 2.224 |
| DeNN | 1.327 | 1.820 |
| KF | **0.648** | **0.914** |

(continued)

| | Protocol 3: Periodically repeat {$S1, \cdots, S5, S6, S6, S6$} | |
|---|---|---|
| GPR | 1.678 | 2.598 |
| BR | 1.843 | 2.366 |
| RFR | 1.810 | 2.297 |
| DeNN | 1.310 | 1.806 |
| KF | **0.667** | **0.846** |
| | Protocol 4: Periodically repeat {$S1, \cdots, S5, S6, S6, S6, S6$} | |
| GPR | 2.043 | 2.999 |
| BR | 2.271 | 3.045 |
| RFR | 2.199 | 2.820 |
| DeNN | 1.706 | 2.387 |
| KF | **0.797** | **1.031** |

In the present SoH method test, the charging profiles of each cell are supposed to rotate among the six scenarios periodically during its whole lifetime. The detailed rotating protocols as well as the results are given in Table 5. The corresponding features are extracted according to each scenario's availability. Specifically, for charging scenario S6, since no time-series feature is available, it is not feasible for the individual estimation models (10) to estimate the capacity value. In such a case, whenever charging scenario S6 is triggered, the capacity remains unchanged from its previous time-step estimate.

It can be seen from Table 5 that within each protocol, the KF always provides better estimation results than any individual ML model. When S6 is activated more frequently, the estimation results of the individual models generally become worse. Most of their estimates deviate from the measurements with a RMSPE greater than 2%, which is unacceptable for vehicle applications. On the contrary, the KF is still very reliable and continuously follows the ground truth at around 1% RMSPE. By comparing different protocols and comparing the results under lab tests to the vehicle usage case, it can be concluded that the advantage of the KF becomes more significant, particularly when charging scenario S6 appears more times. This is because the KF incorporates a capacity prediction model and four capacity estimation models. Even though the estimation models lose efficacy under charging scenario S6, the prediction model developed from histogram data under arbitrary operating conditions is always able to gauge the capacity, and so does the KF that, in such a case, works as an open-loop model-based predictor based on battery usage information. These results corroborate the necessity to use the KF in real-world vehicle battery usage.

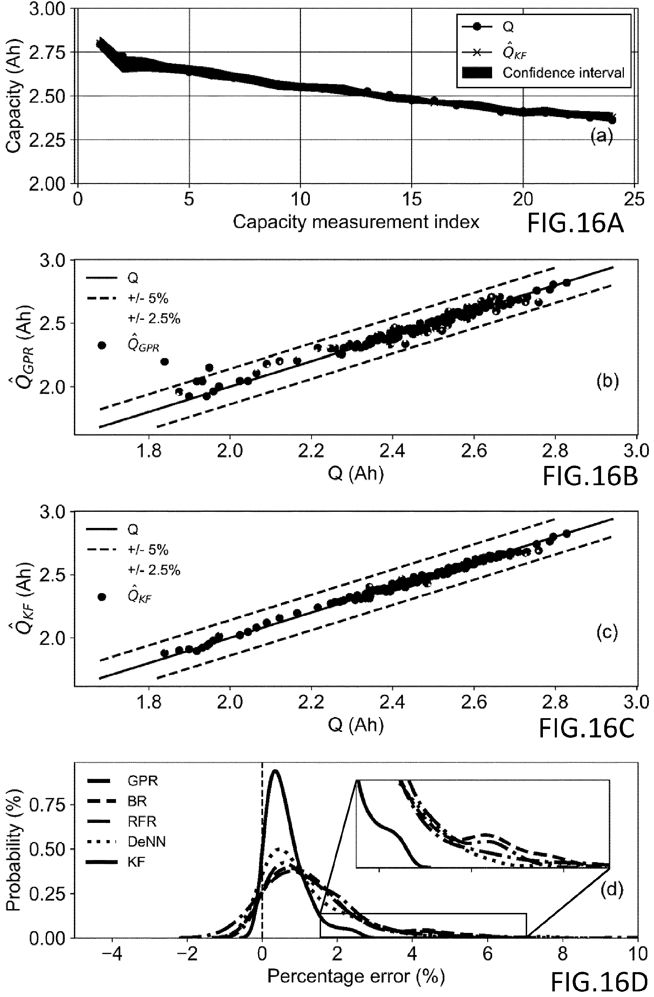

Figure 16A shows the results of a randomly selected NMC-type battery capacity estimation under practical charging cycles. By looking into the detailed estimation result shown in Fig. 16B and figure 16C, the best-performing individual model, i.e., GPR in this case, still has a few estimation points violating the $\pm 2.5\%$ error bounds, whereas the KF manages to contain all estimation points within such error bounds. Under-estimating the capacity will lead to conservative usage, while over-estimation can cause abuse and, in extreme conditions, trigger thermal safety issues. As illustrated in Fig. 16D, the KF has a narrow probability distribution of the estimation errors, closest to zero among all the estimators. This means the KF is much less likely to under- or over-estimate the capacity than all the individual methods.

Since voltage window plays an important role in the developed method, especially when dealing with partial charging scenarios in which it is impossible to select all the voltage windows for feature extraction. With this consideration, the effects of different voltage windows on the estimation performance are investigated. To perform a fair comparison, only voltage window-related features and temperature-related features are included. The detailed numerical results are shown in Table 6, where only the cells that have undergone charging scenario S1 are used in order to access any of the voltage windows. Overall, with a 100 mV voltage interval, the KF's results are all acceptable and meet the average industrial standard of a 2% MAPE, demonstrating the practicability of the proposed model fusion method. It is worth mentioning that the results acquired in Table 4 for different scenarios have adopted the voltage window of 3.65-3.75 V for the voltage window-related features. As can be seen from Table 6, the designed estimators, including both the KF and individual models, will perform much better when the voltage window of 4.05-4.15 V is selected. One hypothesis of such superiority is because this voltage window coincidentally covers an IC peak value, as can be seen from Fig. 4C, and meanwhile, it is also close to the charging profile transition from the CC to CV phase. Nevertheless, a lot of vehicle usage may not fall into such a voltage window, which means that fewer data samples are available.

Table 6: SoH estimation results using different voltage windows

| Algorithm s | 3.55-3.65 (V) | | 3.65-3.75 (V) | | 3.75-3.85 (V) | | 3.85-3.95 (V) | | 3.95-4.05 (V) | | 4.05-4.15 (V) | |
|---|---|---|---|---|---|---|---|---|---|---|---|---|
| | MAPE | RMSPE | MAPE | RMSPE | MAPE | RMSPE | MAPE | RMSPE | MAPE | RMSPE | MAPE | RMSPE |
| GPR | 2.176 | 2.601 | 1.840 | 2.374 | 0.708 | 0.857 | 0.889 | 1.184 | 0.657 | 0.791 | 0.536 | 0.673 |
| BR | 2.062 | 2.642 | 2.118 | 2.776 | 0.810 | 1.032 | 1.846 | 2.413 | 0.789 | 0.971 | 0.642 | 0.764 |
| RFR | 1.763 | 2.308 | 1.751 | 2.321 | 0.830 | 1.046 | 0.970 | 1.264 | 0.766 | 0.986 | 0.672 | 0.884 |
| DeNN | 3.028 | 4.379 | 2.397 | 2.794 | 1.037 | 1.405 | 1.242 | 1.805 | 1.062 | 1.487 | 0.822 | 1.296 |
| KF | 1.98 | 2.405 | 1.853 | 2.344 | 0.701 | 0.856 | 0.894 | 1.195 | 0.625 | 0.759 | 0.532 | 0.672 |

To verify the applicability of the developed method to different types of cell chemistry, the method was also applied it to the NCA-type batteries, and the results are shown in Table 7. In general, the conclusions that were drawn on the NMC-type batteries are also valid here. This indicates that the developed method is sufficiently general to cover batteries with different chemistry and cycling conditions. Comparatively, the estimation accuracy is slightly worse than the result achieved for the NMC-type batteries, especially for the partial charging cases. One hypothesis of this is that the number of data samples in the training set for the NCA-type battery dataset is less than the ones used for the NMC- type batteries. The other possible reason could be that the variance between cells undergoing similar cycling profiles is generally larger than for the NMC-type battery dataset, which naturally increases the estimation challenge.

Table 7: result of different SoH estimation algorithms for NCA batteries

| Algorithms | Scenario 1 | | Scenario 2 | | Scenario 3 | | Scenario 4 | | Scenario 5 | | Scenario 6 | |
|---|---|---|---|---|---|---|---|---|---|---|---|---|
| | MAPE | RMSPE | MAPE | RMSPE | MAPE | RMSPE | MAPE | RMSPE | MAPE | RMSPE | MAPE | RMSPE |
| GPR | 0.493 | 0.672 | 1.247 | 1.542 | 2.234 | 3.097 | 1.139 | 1.478 | 2.100 | 3.038 | - | - |
| BR | 1.014 | 1.277 | 1.154 | 1.431 | 3.295 | 6.308 | 1.316 | 1.594 | 3.197 | 4.684 | - | - |
| RFR | 0.884 | 1.135 | 1.131 | 1.496 | 2.533 | 4.152 | 1.013 | 1.331 | 2.518 | 3.707 | - | - |
| DeNN | 0.845 | 1.083 | 1.475 | 1.946 | **1.952** | **2.662** | 1.248 | 1.687 | **1.962** | **2.809** | - | - |
| KF | **0.493** | **0.671** | **1.024** | **1.332** | 2.399 | 3.702 | **0.997** | **1.321** | 2.274 | 3.375 | **4.124** | **5.392** |

To conclude, the dynamic operating conditions, stochastic user behaviours, and cell-to-cell variations impose great difficulties and challenges in high-fidelity SoH estimation for real-world EV batteries. To tackle this problem, this disclosure describes a practical method to estimate SoH accurately under arbitrary usage profiles. The technical contributions arise from three aspects. First, all possible charging profiles were categorized into six feasible and mutually excluded scenarios, for each of which relevant features were extracted from time-series or histogram data. Second, for each scenario, Bayesian and frequentist-based ML algorithms were used individually to derive SoH estimation models using time-series data. Last, based on an SoH prediction model previously derived from histogram data, a KF was applied to systematically fuse the results of all the models.

Experimental data from batteries of different types illustrated that the proposed model fusion method is able to considerably increase the estimation accuracy and robustness while significantly tightening the confidence interval of the estimation result. For example, the estimates obtained for the entire lifespan of NMC battery cells had a MAPE of 0.631% under a practical operating protocol, and the error was less than 0.8% for all the studied protocols.

Consequently, in general, the obtained input data of the method according to the disclosure is acquired in connection with, or more specifically primarily during, a battery charging phase.

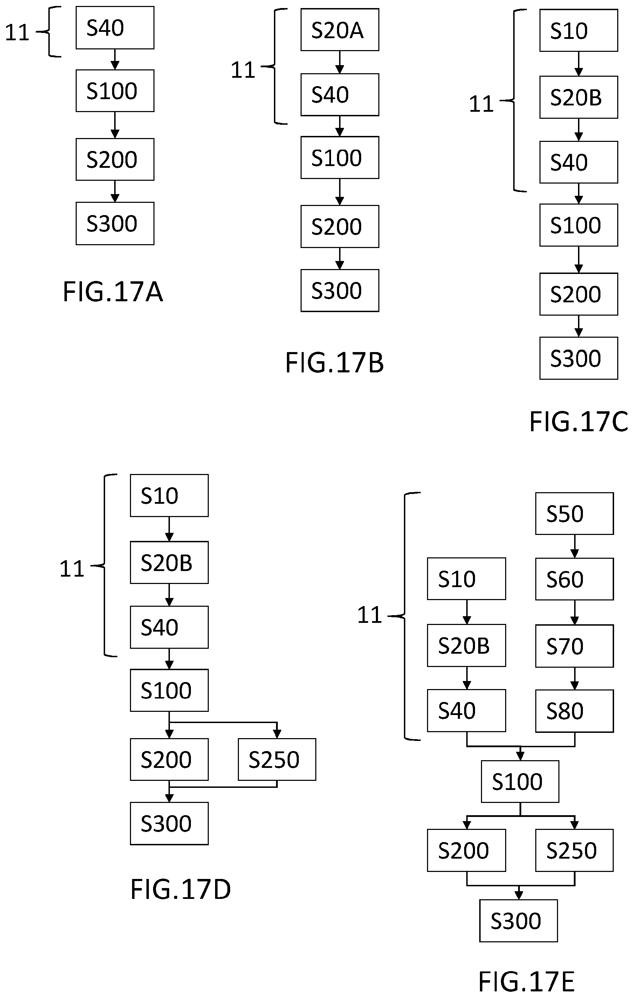

Furthermore, with reference to figure 17A, the method described with reference to figure 2 generally further includes a setup phase 11 performed before the first step S100 of obtaining input data, wherein the setup phase 11 comprises a step S40 that involves selecting appropriate machine learning algorithms and training the machine learning algorithms based on offline battery data. The setup phase 11 is thus typically performed offline, i.e. during vehicle development phase, before starting real-time use.

The offline battery data should preferable include relevant battery features, such as for example times-series of charging current, batter voltage, individual cell voltage levels, discharging current, battery temperature, or the like.

The time-series of offline data may include at least 100 charging events, specifically at least 500 charging events, and more specifically at least 1000 charging events, wherein a charging event may be a full charging, e.g. 0-100% SoC, or a partial charging, e.g. 30 - 80% SoC,

The time-series of offline data may stretch, continuously or discontinuously, over a battery use time period of at least 1 week, specifically at least 1 month, and more specifically at least 6 month.

The offline battery data should preferable be derived from the same, or at least similar, type of battery cells as intended to be monitored by the present method and system for enabling a more reliable estimation result from the machine learning algorithms.

The input data obtained in the first step S100 may also be referred to as online data, because it stems from measurements on the battery to be monitored by the present battery SoH method. In the beginning, no online data from battery to be monitored is available, because the battery is new. However, over time, the online data from battery to be monitored is slowly building up if the battery is regularly used.

The input data may for example obtained from battery sensors, such as one or more current sensor(s), voltage sensor(s) and/or temperature sensor(s) associated with the battery, or with an electrical device connected to the battery.

The online battery SoH estimation performed by the method/system according to the disclosure may be implemented in an electronic control unit adjacent and/or associated with the battery. In other words, the online battery SoH estimation may be provided more or less in real-time, for example in connection with a recent charging event. However, according to an alternative solution, the online battery SoH estimation performed by the method/system according to the disclosure may be implemented in a remote cloud computing service or similar type of remote server solution. Such a solution would then require data transfer from the battery controller to a remote server. Moreover, the online battery SoH estimation may alternatively be performed after a certain delay, such as for example within 24 hours from the most recent charging event.

With reference to figure 17B, the setup phase 11 of the method may according to some example embodiments further include a step S20A of selecting the set of predetermined battery features. This selection step involves selecting one or more of the following battery features, based on the latest battery charging event: voltage curve profile; current curve profile; time interval between a predefined voltage window; signal strength over time, which is calculated as

$$E = \int_0^\infty s(t)^2 dt$$, where s(t) is the signal; the area under the current curve; the area under the voltage curve; the slope of the voltage curve; the slope of the current curve [in the CV phase could serve as a feature if there is a CV phase in the charging profile]; initial SoC; final SoC, charging temperature-related features; incremental capacity curve peak value; incremental capacity curve voltage level at peak value; final total battery output voltage; final individual cell voltage; and differential voltage curve.

With reference to figure 17C, according to some example embodiments, the setup phase 11 of the method may further comprise a step S10 of selecting a set of unique full and/or partial charging scenarios (S1-S5), each having an unique charging start and/or charging stop position; and training the machine learning algorithms separately for each of the selected charging scenario S1-S5 and based on a data set that corresponds to the selected charging scenario S1-S5, wherein the step S100 of obtaining input data involves determining which one of the unique full and/or partial charging scenarios (S1-S5) the obtained input data corresponds to, and wherein the step S200 of applying a plurality of machine learning algorithms to conduct state of health estimation of the battery involves, for each of the machine learning algorithms, applying the machine learning algorithm that is trained on data associated with the determined charging scenario (S1-S5) for calculating said estimation of state of health of the battery, as well as said quantitative estimation of a confidence interval/value of the state of health estimation of the battery.

With reference to figure 17C again, the step S20B of selecting predetermined battery features may then involve selecting one set of predetermined battery features indicating State of Health of the battery for each charging scenario (S1-S5) of the set of unique charging scenarios (S1-S5), and the predetermined battery features of at least one charging scenario (S1-S5) of the set of unique charging scenarios (S1-S5) differs from the predetermined battery features of another charging scenario (S1-S5) of the set of unique charging scenarios (S1-S5). The battery features of each charging scenario are thus typically selected for providing a more or less optimal fit to the specific charging scenario. In some example embodiments, each charging scenario has a unique set of selected battery features, and in other example embodiments, some charging scenarios may have the same set of selected battery features, but generally not all, depending the circumstances of each specific implementation.

According to some example embodiments , the step S20B of selecting predetermined battery features may involve, for each of the sets of predetermined battery features indicating State of Health of the battery, first identifying a set of preliminary battery features that jointly indicates state of health of the battery, and subsequently performing a correlation analysis of the preliminary battery features.

The correlation analysis may for example be Spearman analysis or the like that is performed by means of an algorithm in a computer. The purpose of the correlation analysis is to eliminate redundant features and thus improving estimation quality and/or calculation efficiency.

As described above with reference to in particular figure 6 - 12E, the method may according to some example embodiments, as illustrated in figure 17D, include a step S250 of calculating a battery SoH prediction by means of a histogram data-based machine learning prediction model, as well as quantitative estimation of a confidence interval/value of said battery SoH prediction, based on the obtained battery input data in step S100, and subsequently in step 300 applying said Kalman filter (KF)-based fusion algorithm for combining the battery state of health estimations from all of said plurality of machine learning algorithms and the battery SoH prediction from said histogram data-based machine learning prediction model for providing a fused battery state of health estimation. Thereby, a reasonably reliable and accurate battery SoH estimation may be provided also when the most recent charging event did not match any of the predetermined charging scenarios S1-S5, i.e. when the ML algorithms of step S200 cannot provide an accurate SoH estimation.

According to some example embodiments, the step of calculating battery SoH prediction by means of a histogram data-based machine learning prediction model may involve an offline setup phase that includes, a step S50 of obtaining historical battery usage data, a subsequent step S60 of converting battery usage data to 1D histogram and extracting statistical properties from said 1D histogram, and thereafter a step S70 of determining battery features based on extracting statistical properties, and finally a step S80 of providing a global model by selecting and offline training of a machine learning algorithm based on the obtained historical battery usage data, and wherein the step S250 of calculating battery SoH prediction by means of a histogram data-based machine learning prediction model during online use of the battery involves: calculating a global prediction of the battery SoH based on the global model; and adapting the global prediction of the battery SoH online based on measured historical battery capacity estimation values of the present battery (5) for providing a final battery SoH prediction.

The above-mentioned step 70 of determining battery features based on extracting statistical properties may additionally involve, first identifying a set of preliminary battery features, based on extracting statistical properties that jointly indicates state of health of the battery, and subsequently performing a correlation analysis of the preliminary battery features. As described above, the correlation analysis may for example be Spearman analysis or the like that is performed by means of an algorithm in a computer. The purpose of the correlation analysis is to eliminate redundant features and thus improving estimation quality and/or calculation efficiency.

According to some example embodiments, the set of unique charging scenarios (S1-S5) may for example include one or more of the following battery charging scenarios: Complete full Constant Current (CC) - Constant Voltage (CV) charging; partial CC-CV charging involving starting after the Incremental Capacity (IC) curve peak value and ending with the complete Constant Voltage (CV) phase; partial Constant Current (CC) - Constant Voltage (CV) charging when starting after the Incremental Capacity (IC) curve peak value and ending without Constant Voltage (CV) phase; Partial Constant Current (CC) - Constant Voltage (CV) charging when starting before the Incremental Capacity (IC) curve peak value and ending with the complete Constant Voltage (CV) phase; Partial Constant Current (CC) - Constant Voltage (CV) charging when starting before the IC peak value and ending without Constant Voltage (CV) phase. These battery charging scenarios are deemed to represent commonly used charging scenarios in real-use of a battery application, such as in particular a battery electric vehicle.

In other words, set of individual charging scenarios (S1-S5) may include both a full charging scenario and one or more partial charging scenarios (S1-S5).

According to some example embodiments, the method involves setting the final battery state of health estimation equal to the battery SoH prediction as derived by means of the histogram data-based machine learning prediction model when the obtained input data does not correspond to any of the set of unique charging scenarios (S1-S5) In other words, when the most recent charging event involves for example pulse charging or dynamic charging or some other type of charging profile that does not fall under any of the predetermined charging scenarios S1-S5t, the resulting battery state of health estimation provided by the method may be set equal to the battery SoH prediction as derived by means of the histogram data-based machine learning prediction model, because the estimation models will not be able to provide any reliable estimation result in such a charging event.

With reference to figure 1, the disclosure also relates to a system for real-time estimation of state of health of a rechargeable battery. The system comprises a rechargeable battery 5, and a set of sensors 12 configured for sensing a set of battery features on the rechargeable battery 5. The set of battery features are selected for their capacity to jointly provide an indication of the State of Health of the battery 5. The system also comprises an electronic control unit 13, i.e. an ECU, that is connected to the set of sensors 12 and configured to obtain input data relating to the set of predetermined battery features, and to apply a plurality of, in particular four, machine learning algorithms to conduct real-time state of health estimation of the battery, wherein each machine learning algorithm, based on obtained input data from the battery features, is configured to calculate an estimation of state of health of the battery, as well as quantitative estimation of a confidence interval/value of the state of health estimation of the battery 5, Finally, the ECU in configured to apply a Kalman filter (KF)-based fusion algorithm for combining the state of health estimations from all of said plurality of machine learning algorithms, for providing a fused state of health estimation.

With reference to figure 1, the disclosure also relates to a vehicle 1 comprising the system described above.

The disclosure also relates to an electronic control unit 13 comprising a processor configured to perform the method described above.

In addition the disclosure concerns a computer program comprising instructions which, when the program is executed by a computer, cause the computer to carry out the steps of the method described above.

The present disclosure has been presented above with reference to specific embodiments. However, other embodiments than the above described are possible and within the scope of the disclosure. Different method steps than those described above, performing the method by hardware or software, may be provided within the scope of the disclosure.

The methods disclosed herein may be implemented in a general purpose computer, a processor, or a processor core. Suitable processors include, by way of example, a general purpose processor, a special purpose processor, a conventional processor, a digital signal processor (DSP), a plurality of microprocessors, one or more microprocessors in association with a DSP core, a controller, a microcontroller, Application Specific Integrated Circuits (ASICs), Field Programmable Gate Arrays (FPGAs) circuits, any other type of integrated circuit (IC), and/or a state machine.

The methods or flow charts provided herein may be implemented in a computer program, software, or firmware incorporated in a computer-readable storage medium for execution by a general purpose computer or a processor. Examples of computer-readable storage mediums include a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs).

Thus, according to an exemplary embodiment, there is provided a non-transitory computer-readable storage medium storing one or more programs configured to be executed by one or more processors of the system for estimation of state of health of a rechargeable battery., the one or more programs comprising instructions for performing the method according to any one of the above-discussed embodiments. Alternatively, according to another exemplary embodiment a cloud computing system can be configured to perform any of the method aspects presented herein. The cloud computing system may comprise distributed cloud computing resources that jointly perform the method aspects presented herein under control of one or more computer program products. Moreover, the processor may be connected to one or more communication interfaces and/or sensor interfaces for receiving and/transmitting data with external entities such as e.g. sensors arranged on the vehicle surface, an off-site server, or a cloud-based server.

The processor(s) associated with the system for estimation of state of health of a rechargeable battery may be or include any number of hardware components for conducting data or signal processing or for executing computer code stored in memory. The system may have an associated memory, and the memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made without departing from the scope of the present disclosure as defined in the claims. Furthermore, modifications may be made to adapt a particular situation or material to the teachings of the present disclosure without departing from the essential scope thereof. Although discussed above as methods described by the flowcharts of Figure 17A-17E, it should be appreciated that the operations may be performed in any order and do not necessarily imply an order as provided. Rather, the methods discussed are merely one embodiment of the present disclosure as contemplated.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the appended claims. Reference signs mentioned in the claims should not be seen as limiting the extent of the matter protected by the claims, and their sole function is to make claims easier to understand.

REFERENCE SIGNS

1. Vehicle
2. front wheels
3. rear wheels/
4. passenger compartment
5. high-voltage battery
6. electric machine
7. charging inlet
8. lower voltage level
9. upper voltage level
10. IC peak value
11. setup phase
12. Sensors
13. ECU

$$\left(\frac{dQ}{dV}\right)_{max}$$

The peak value on the IC curve.

$\Delta I_{CV}$ The slope of the current during CV charging phase.

$\Delta t$ Time spent in the defined voltage window.

$\Delta V$ The slope of the voltage in the defined voltage window.

$E_U$ The energy of the voltage signal.

$SoC_0$ Initial SoC level when charging starts.

$T_{max}$ Maximum temperature during charging.

$T_{min}$ Minimum temperature during charging.

$t_{cc}$ The time spent during CC charging stage.

$$U_{\frac{dQ}{dVmax}}$$

The voltage corresponding to when IC has peak value.

**Claims**

1. A method for estimation of state of health of a rechargeable battery (5), the method comprising:

obtaining input data of a set of predetermined battery features that jointly indicates State of Health of the battery (5),

applying a plurality of machine learning algorithms to conduct state of health estimation of the battery (5), wherein each machine learning algorithm, based on obtained input data from the battery features, calculates an estimation of state of health of the battery (5), as well as quantitative estimation of a confidence interval/value of the state of health estimation of the battery (5), and

applying a Kalman filter based fusion algorithm for combining the state of health estimations from all of said plurality of machine learning algorithms, for providing a fused state of health estimation.

2. A method according to claim 1, wherein the obtained input data is acquired in connection with a battery charging phase.

3. A method according to any of the preceding claims, wherein the method further includes a setup phase performed before the step of obtaining input data, wherein the setup phase comprises training the machine learning algorithms.

4. A method according to any of the preceding claims, wherein the predetermined battery features includes one or more of the following battery features, based on the latest battery charging event: voltage curve profile; current curve profile; time interval between a predefined voltage window; signal strength over time, which is calculated as

$$E = \int_0^\infty s(t)^2 dt$$

, where s(t) is the signal; the area under the current curve; the area under the voltage curve; the slope of the voltage curve; the slope of the current curve; initial SoC; final SoC, charging temperature-related features; incremental capacity curve peak value; incremental capacity curve voltage level at peak value; final total battery output voltage; final individual cell voltage; and differential voltage curve.

5. A method according to any of the preceding claims,

wherein the method further includes a setup phase comprising selecting a set of unique charging scenarios (S1-S5), each having an unique charging start and/or charging stop position; and training the machine learning algorithms separately for each of the selected charging scenario S1-S5 and based on a data set that corresponds to the selected charging scenario S1-S5,
wherein the step of obtaining input data involves determining which one of the unique charging scenarios (S1-S5) the obtained input data corresponds to, and
wherein the step of applying a plurality of machine learning algorithms to conduct state of health estimation of the battery (5) involves, for each of the machine learning algorithms, applying the machine learning algorithm that is trained on data associated with the determined charging scenario (S1-S5) for calculating said estimation of state of health of the battery (5), as well as said quantitative estimation of a confidence interval/value of the state of health estimation of the battery (5).

6. A method according to claim 5, wherein one set of predetermined battery features indicating State of Health of the battery (5) is selected for each charging scenario (S1-S5) of the set of unique charging scenarios (S1-S5), and wherein the predetermined battery features of at least one charging scenario (S1-S5) of the set of unique charging scenarios (S1-S5) differs from the predetermined battery features of another charging scenario (S1-S5) of the set of unique charging scenarios (S1-S5).

7. A method according to any of the preceding claims, wherein each of the sets of predetermined battery features indicating State of Health of the battery (5) is determined by:

first identifying a set of preliminary battery features that jointly indicates state of health of the battery (5),
performing a correlation analysis of the preliminary battery features.

8. A method according to any of the preceding claims, further comprising:

calculating a battery SoH prediction by means of a histogram data-based machine learning prediction model, as well as quantitative estimation of a confidence interval/value of said battery SoH prediction, and
applying said Kalman filter based fusion algorithm for combining the battery state of health estimations from all of said plurality of machine learning algorithms and the battery SoH prediction from said histogram data-based machine learning prediction model for providing a fused battery state of health estimation.

9. A method according to claim 8, wherein the step of calculating battery SoH prediction by means of a histogram data-based machine learning prediction model involves a setup phase that includes,

obtaining historical battery usage data,

converting battery usage data to 1D histogram and extracting statistical properties from said 1D histogram,

determining battery features based on extracting statistical properties,

providing a global model by selecting and offline training of a machine learning algorithm based on the obtained historical battery usage data,

and wherein the step of calculating battery SoH prediction by means of a histogram data-based machine learning prediction model during online use of the battery involves:

calculating a global prediction of the battery SoH based on the global model; and

adapting the global prediction of the battery SoH online based on measured historical battery capacity estimation values of the present battery (5) for providing a final battery SoH prediction.

10. A method according to any of claim 5 to 9, wherein the set of unique charging scenarios (S1-S5) includes one or more of the following battery charging scenarios: Complete full Constant Current, CC, Constant Voltage, CV, charging; partial CC-CV charging involving starting after the Incremental Capacity , IC, curve peak value and ending with the complete Constant Voltage, CV, phase; partial Constant Current, CC, Constant Voltage, CV, charging when starting after the Incremental Capacity, IC, curve peak value and ending without Constant Voltage, CV, phase; Partial Constant Current, CC, - Constant Voltage, CV, charging when starting before the Incremental Capacity, IC, curve peak value and ending with the complete Constant Voltage, CV, phase; Partial Constant Current, CC, Constant Voltage, CV, charging when starting before the IC peak value and ending without Constant Voltage, CV, phase.

11. A method according to any of the preceding claims 8 to 10, comprising setting the battery state of health estimation equal to the battery SoH prediction as derived by means of the histogram data-based machine learning prediction model when the obtained input data does not correspond to any of the set of unique charging scenarios (S1-S5).

12. A system for estimation of state of health of a rechargeable battery (5), the system comprising:

a rechargeable battery (5);

a set of sensors configured for sensing a set of battery features on the rechargeable battery (5), wherein the set of battery features jointly indicate State of Health of the battery (5);

an electronic control unit connected with the set of sensors and configured to:

obtain input data relating to the set of predetermined battery features,

apply a plurality of machine learning algorithms to conduct state of health estimation of the battery (5), wherein each machine learning algorithm, based on obtained input data from the battery features, calculates an estimation of state of health of the battery (5), as well as quantitative estimation of a confidence interval/value of the state of health estimation of the battery (5), and

apply a Kalman filter based fusion algorithm for combining the state of health estimations from all of said plurality of machine learning algorithms, for providing a fused state of health estimation.

13. A vehicle comprising the system according to claim 12.

14. A data processing control unit comprising a processor configured to perform the steps of the method of any of claims 1 to 11.

15. A computer program comprising instructions which, when the program is executed by a computer, cause the computer to carry out the steps of the method of any of claims 1 to 11.

**Patentansprüche**

1. Verfahren zum Schätzen des Gesundheitszustands einer wiederaufladbaren Batterie (5), wobei das Verfahren umfasst:

Erhalten von Eingabedaten für einen Satz von vorbestimmten Batterienmerkmalen, die zusammen den Gesundheitszustand der Batterie anzeigen (5),

Anwenden einer Mehrzahl von Algorithmen für maschinelles Lernen zur Durchführung einer Gesundheitszustandsschätzung der Batterie (5), wobei jeder Algorithmus für maschinelles Lernen auf der Grundlage der erhaltenen Eingabedaten von den Batteriemerkmalen eine Schätzung des Gesundheitszustands der Batterie (5) sowie eine quantitative Schätzung eines Konfidenzintervalls/Wertes der Gesundheitszustandsschätzung der Batterie (5) berechnet, und

Anwenden eines auf Kalman-Filter basierten Fusionsalgorithmus zur Kombination der Gesundheitszustandsschätzungen von allen der Mehrzahl von Algorithmen für maschinelles Lernen, um eine fusionierte Gesundheitszustandsschätzung bereitzustellen.

2. Verfahren nach Anspruch 1, wobei die erhaltenen Eingabedaten in Verbindung mit einer Batterieladephase erfasst werden.

3. Verfahren nach einem der vorhergehenden Ansprüche, wobei das Verfahren ferner eine Einrichtungsphase beinhaltet, die vor dem Schritt des Erhaltens von Eingabedaten durchgeführt wird, wobei die Einrichtungsphase das Trainieren der Algorithmen für maschinelles Lernen umfasst.

4. Verfahren nach einem der vorhergehenden Ansprüche, wobei die vorbestimmten Batteriemerkmale auf der Grundlage des letzten Batterieladeereignisses eines oder mehrere der folgenden Batteriemerkmale umfassen: Spannungskurvenprofil; Stromkurvenprofil; Zeitintervall zwischen einem vordefinierten Spannungsfenster; Signalstärke über die Zeit, die als $E = \int_0^\infty s(t)^2 dt$ berechnet wird, wobei s(t) das Signal ist; die Fläche unter der Stromkurve; die Fläche unter der Spannungskurve; die Steigung der Spannungskurve; die Steigung der Stromkurve; Ausgangs-SoC; End-SoC, Merkmale in Zusammenhang mit der Ladetemperatur; Spitzenwert der Inkrementelle-Kapazität-Kurve; Spannungshöhe der Inkrementelle-Kapazität-Kurve beim Spitzenwert; Endgesamtbatterieausgangsleistung; Endspannung einzelner Zellen; und differentielle Spannungskurve.

5. Verfahren nach einem der vorstehenden Ansprüche,

wobei das Verfahren ferner eine Einrichtungsphase beinhaltet, die das Auswählen eines Satzes von eindeutigen Ladeszenarien (S1-S5), von denen jedes eine eindeutige Ladestart- und/oder Ladestoppposition aufweist; und das Trainieren der Algorithmen für maschinelles Lernen für jedes der ausgewählten Ladeszenarien S1-S5 separat und auf der Grundlage eines Datensatzes umfasst, der dem ausgewählten Ladeszenario S1-S5 entspricht,

wobei der Schritt des Erhaltens von Eingabedaten das Bestimmen umfasst, welchem der eindeutigen Ladeszenarien (S1-S5) die erhaltenen Eingabedaten entsprechen, und

wobei der Schritt des Anwendens einer Mehrzahl von Algorithmen für maschinelles Lernen zur Durchführung der Gesundheitszustandsschätzung der Batterie (5) für jeden der Algorithmen für maschinelles Lernen das Anwenden des Algorithmus für maschinelles Lernen, der mit Daten trainiert wird, die dem bestimmten Ladeszenario (S1-S5) zugeordnet sind, zum Berechnen der Schätzung des Gesundheitszustands der Batterie (5) sowie der quantitativen Schätzung eines Konfidenzintervalls/Wertes der Gesundheitszustandsschätzung der Batterie (5) beinhaltet.

6. Verfahren nach Anspruch 5, wobei ein Satz von vorbestimmten Batteriemerkmalen, die den Gesundheitszustand der Batterie (5) anzeigen, für jedes Ladeszenario (S1-S5) des Satzes von eindeutigen Ladeszenarien (S1-S5) ausgewählt wird, und wobei sich die vorbestimmten Batteriemerkmale von mindestens einem Ladeszenario (S1-S5) des Satzes von eindeutigen Ladeszenarien (S1-S5) von den vorbestimmten Batteriemerkmalen eines anderen Ladeszenarios (S1-S5) des Satzes von eindeutigen Ladeszenarien (S1-S5) unterscheiden.

7. Verfahren nach einem der vorhergehenden Ansprüche, wobei jeder der Sätze von vorbestimmten Batteriemerkmalen, die den Gesundheitszustand der Batterie (5) anzeigen, bestimmt wird durch:

zunächst Identifizieren eines Satzes von vorläufigen Batteriemerkmalen, die zusammen den Gesundheitszustand der Batterie (5) anzeigen,

Durchführen einer Korrelationsanalyse der vorläufigen Batteriemerkmale.

8. Verfahren nach einem der vorstehenden Ansprüche, das ferner umfasst:

Berechnen einer Batterie-SoH-Vorhersage mittels eines auf Histogrammdaten basierten Vorhersagemodells für maschinelles Lernen sowie einer quantitativen Schätzung eines Konfidenzintervalls/Wertes der Batterie-SoH-Vorhersage, und

Anwenden des auf Kalman-Filter basierten Fusionsalgorithmus zur Kombination der Batteriegesundheitszustandsschätzungen von allen der Mehrzahl von Algorithmen für maschinelles Lernen und der Batterie-SoH-Vorhersage von dem auf Histogrammdaten basierten Vorhersagemodell für maschinelles Lernen zur Bereitstellung einer fusionierten Batteriegesundheitszustandsschätzung.

9. Verfahren nach Anspruch 8, wobei der Schritt des Berechnens der Batterie-SoH-Vorhersage mittels eines auf Histogrammdaten basierten Vorhersagemodells für maschinelles Lernen eine Einrichtungsphase einschließt, die beinhaltet

Erhalten historischer Batterienutzungsdaten,
Umwandeln von Batterienutzungsdaten in 1D-Histogramme und Extrahieren statistischer Eigenschaften aus dem 1D-Histogramm,
Bestimmen der Batteriemerkmale auf der Grundlage des Extrahierens statistischer Eigenschaften,
Bereitstellen eines globalen Modells durch Auswählen und Offline-Trainieren eines Algorithmus für maschinelles Lernen auf der Grundlage der erhaltenen historischen Batterienutzungsdaten,
und wobei der Schritt des Berechnens der Batterie-SoH-Vorhersage mittels eines auf Histogrammdaten basierten Vorhersagemodells für maschinelles Lernen während der Online-Nutzung der Batterie einschließt:

Berechnen einer globalen Vorhersage des Batterie-SoH auf der Grundlage des globalen Modells; und
Anpassen der globalen Vorhersage des Batterie-SoH online auf der Grundlage von gemessenen historischen Schätzwerten der Batteriekapazität der aktuellen Batterie (5) zur Bereitstellung einer finalen Batterie-SoH-Vorhersage.

10. Verfahren nach einem der Ansprüche 5 bis 9, wobei der Satz von eindeutigen Ladeszenarien (S1-S5) eines oder mehrere der folgenden Batterieladeszenarien beinhaltet: vollständiges Laden mit vollem Konstantstrom, CC, und Konstantspannung, CV; teilweises CC-CV-Laden mit Starten nach dem Spitzenwert der Kurve der inkrementellen Kapazität, IC, und Beenden mit vollständiger Phase der Konstantspannung, CV; teilweises Laden mit Konstantstrom, CC, und Konstantspannung, CV, beim Starten nach dem Spitzenwert der Kurve der inkrementellen Kapazität, IC, und Beenden ohne Phase der Konstantspannung, CV; teilweises Laden mit Konstantstrom, CC, und Konstantspannung, CV, beim Starten vor dem Spitzenwert der Kurve der inkrementellen Kapazität, IC, und Enden mit der vollständigen Phase der Konstantspannung, CV; teilweises Laden mit Konstantstrom, CC, und Konstantspannung, CV, beim Starten vor dem IC-Spitzenwert und Beenden ohne Phase der Konstantspannung, CV.

11. Verfahren nach einem der vorhergehenden Ansprüche 8 bis 10, das das Gleichsetzen der Batteriegesundheitszustandsschätzung auf die Batterie-SoH-Vorhersage umfasst, die mit Hilfe des auf Histogrammdaten basierten Vorhersagemodells für maschinelles Lernen abgeleitet wurde, wenn die erhaltenen Eingabedaten keinem der Sätze von eindeutigen Ladeszenarien (S1-S5) entsprechen.

12. System zum Schätzen des Gesundheitszustands einer wiederaufladbaren Batterie (5), wobei das System umfasst:

eine wiederaufladbare Batterie (5);
einen Satz von Sensoren, die für das Erfassen eines Satzes von Batteriemerkmalen auf der wiederaufladbaren Batterie (5) konfiguriert sind, wobei der Satz von Batteriemerkmalen zusammen den Gesundheitszustand der Batterie (5) anzeigt;
eine elektronische Steuereinheit, die mit dem Satz von Sensoren verbunden und dazu konfiguriert ist:

Erhalten von Eingabedaten in Zusammenhang mit dem Satz von vorbestimmten Batteriemerkmalen,
Anwenden einer Mehrzahl von Algorithmen für maschinelles Lernen zur Durchführung einer Gesundheitszustandsschätzung der Batterie (5), wobei jeder Algorithmus für maschinelles Lernen auf der Grundlage der erhaltenen Eingabedaten von den Batteriemerkmalen eine Schätzung des Gesundheitszustands der Batterie (5) sowie eine quantitative Schätzung eines Konfidenzintervalls/Wertes der Gesundheitszustandsschätzung der Batterie (5) berechnet, und
Anwenden eines auf Kalman-Filter basierten Fusionsalgorithmus zur Kombination der Gesundheitszustandsschätzungen von allen der Mehrzahl von Algorithmen für maschinelles Lernen, um eine fusionierte Gesundheitszustandsschätzung bereitzustellen.

13. Fahrzeug, das das System nach Anspruch 12 umfasst.

**14.** Datenverarbeitungssteuereinheit, die einen Prozessor umfasst, der konfiguriert ist, um die Schritte des Verfahrens nach einem der Ansprüche 1 bis 11 durchzuführen.

**15.** Computerprogramm, das Anweisungen umfasst, die, wenn das Programm von einem Computer ausgeführt wird, den Computer dazu veranlassen, die Schritte des Verfahrens nach einem der Ansprüche 1 bis 11 auszuführen.

**Revendications**

**1.** Procédé d'estimation de l'état de santé d'une batterie rechargeable (5), le procédé comprenant :

l'obtention de données d'entrée d'un ensemble de caractéristiques prédéterminées de batterie qui indiquent conjointement l'état de santé de la batterie (5),
l'application d'une pluralité d'algorithmes d'apprentissage automatique pour effectuer une estimation de l'état de santé de la batterie (5), dans lequel chaque algorithme d'apprentissage automatique, sur la base des données d'entrée obtenues à partir des caractéristiques de batterie, calcule une estimation de l'état de santé de la batterie (5), ainsi qu'une estimation quantitative d'un intervalle/d'une valeur de confiance de l'estimation de l'état de santé de la batterie (5), et
l'application d'un algorithme de fusion basé sur un filtre de Kalman pour combiner les estimations de l'état de santé provenant de tous lesdits pluralité d'algorithmes d'apprentissage automatique, afin de fournir une estimation fusionnée de l'état de santé.

**2.** Procédé selon la revendication 1, dans lequel les données d'entrée obtenues sont acquises en relation avec une phase de charge de batterie.

**3.** Procédé selon l'une quelconque des revendications précédentes, dans lequel le procédé inclut en outre une phase de configuration effectuée avant l'étape d'obtention des données d'entrée, dans lequel la phase de configuration comprend l'entraînement des algorithmes d'apprentissage automatique.

**4.** Procédé selon l'une quelconque des revendications précédentes, dans lequel les caractéristiques prédéterminées de batterie incluent une ou plusieurs des caractéristiques suivantes de la batterie, sur la base du dernier événement de charge de batterie : profil de courbe de tension ; profil de courbe de courant ; intervalle de temps entre une fenêtre de tension prédéfinie ; intensité de signal au fil du temps, qui est calculée comme $\mathbb{E} = \int_0^\infty s(t)2\, dt$, où s (t) est le signal ; l'aire sous la courbe de courant ; l'aire sous la courbe de tension ; la pente de la courbe de tension ; la pente de la courbe de courant ; le SoC initial ; le SoC final ; les caractéristiques liées à la température de charge ; la valeur maximale de la courbe de capacité incrémentielle ; le niveau de tension de courbe de capacité incrémentielle à une valeur maximale ; la tension de sortie totale finale de batterie ; la tension finale de chaque cellule ; et la courbe de tension différentielle.

**5.** Procédé selon l'une quelconque des revendications précédentes,

dans lequel le procédé comprend en outre une phase de configuration comprenant la sélection d'un ensemble de scénarios de charge uniques (S1-S5), chacun ayant une position de début de charge et/ou d'arrêt de charge unique ; et l'entraînement des algorithmes d'apprentissage automatique séparément pour chacun des scénarios de charge sélectionnés S1-S5 et sur la base d'un ensemble de données qui correspond au scénario de charge sélectionné S1-S5,
dans lequel l'étape d'obtention des données d'entrée implique la détermination de celui des scénarios de charge uniques (S1-S5) auquel correspondent les données d'entrée obtenues, et
dans lequel l'étape d'application d'une pluralité d'algorithmes d'apprentissage automatique pour effectuer une estimation de l'état de santé de batterie (5) implique, pour chacun des algorithmes d'apprentissage automatique, l'application de l'algorithme d'apprentissage automatique qui est entraîné sur des données associées au scénario de charge déterminé (S1-S5) pour calculer ladite estimation de l'état de santé de la batterie (5), ainsi que ladite estimation quantitative d'un intervalle/d'une valeur de confiance de l'estimation de l'état de santé de la batterie (5).

**6.** Procédé selon la revendication 5, dans lequel un ensemble de caractéristiques prédéterminées de batterie indiquant l'état de santé de la batterie (5) est sélectionné pour chaque scénario de charge (S1-S5) de l'ensemble de scénarios de charge uniques (S1-S5), et dans lequel les caractéristiques prédéterminées de batterie d'au moins un scénario de charge (S1-S5) de l'ensemble de scénarios de charge uniques (S1-S5) diffèrent des caractéristiques prédéterminées de batterie d'un autre scénario de charge (S1-S5) de l'ensemble de scénarios de charge uniques (S1-S5).

7. Procédé selon l'une quelconque des revendications précédentes, dans lequel chacun des ensembles de caractéristiques prédéterminées de batterie indiquant l'état de santé de batterie (5) est déterminé par :

> l'identification préalable d'un ensemble de caractéristiques préliminaires de batterie qui indiquent conjointement l'état de santé de la batterie (5),
> la réalisation d'une analyse de corrélation des caractéristiques préliminaires de batterie.

8. Procédé selon l'une quelconque des revendications précédentes, comprenant en outre :

> le calcul d'une prédiction de l'état de santé de batterie au moyen d'un modèle de prédiction d'apprentissage automatique basé sur des données d'histogramme, ainsi que l'estimation quantitative d'un intervalle/d'une valeur de confiance de ladite prédiction de l'état de santé de batterie, et
> l'application dudit algorithme de fusion basé sur le filtre de Kalman pour combiner les estimations de l'état de santé de batterie provenant de tous lesdits algorithmes d'apprentissage automatique et la prédiction de l'état de santé de batterie provenant dudit modèle de prédiction d'apprentissage automatique basé sur des données d'histogramme afin de fournir une estimation fusionnée de l'état de santé de batterie.

9. Procédé selon la revendication 8, dans lequel l'étape consistant à calculer la prédiction de l'état de santé de batterie à l'aide d'un modèle de prédiction d'apprentissage automatique basé sur des données d'histogramme implique une phase de configuration qui inclut

> l'obtention de données historiques d'utilisation de batterie,
> la conversion des données d'utilisation de batterie en histogramme 1D et l'extraction de propriétés statistiques à partir dudit histogramme 1D,
> la détermination des caractéristiques de batterie sur la base de l'extraction des propriétés statistiques,
> la fourniture d'un modèle global par la sélection et l'entraînement hors ligne d'un algorithme d'apprentissage automatique basé sur les données historiques d'utilisation de la batterie obtenues, et
> dans lequel l'étape de calcul de la prédiction de l'état de santé de la batterie au moyen d'un modèle de prédiction d'apprentissage automatique basé sur des données d'histogramme pendant l'utilisation en ligne de la batterie implique :

>> le calcul d'une prédiction globale de l'état de santé de batterie sur la base du modèle global ; et
>> l'adaptation en ligne de la prédiction globale de l'état de santé de batterie sur la base des valeurs d'estimation de capacité historique mesurée de la batterie actuelle (5) afin de fournir une prédiction finale de l'état de santé de batterie.

10. Procédé selon l'une quelconque des revendications 5 à 9, dans lequel l'ensemble de scénarios de charge uniques (S1-S5) inclut un ou plusieurs des scénarios de charge de batterie suivants : Charge complète à courant constant, CC, - tension constante, CV; charge partielle CC-CV impliquant un démarrage après la valeur maximale de courbe de capacité incrémentielle, IC, et se terminant par la phase complète à tension constante, CV; charge partielle à courant constant, CC, - tension constante, CV, lorsque le démarrage a lieu après la valeur maximale de courbe de capacité incrémentielle, IC, et se termine sans phase à tension constante, CV; Charge partielle à courant constant, CC, - tension constante, CV, lorsque le démarrage a lieu avant la valeur maximale de courbe de capacité incrémentielle, IC, et se termine par la phase complète à tension constante, CV; Charge partielle à courant constant, CC, - tension constante, CV, lorsque le démarrage a lieu avant la valeur maximale de courbe IC et se termine sans phase à tension constante, CV.

11. Procédé selon l'une quelconque des revendications 8 à 10 précédentes, comprenant la définition de l'estimation de l'état de santé de batterie comme étant égale à la prédiction de l'état de santé de batterie telle que dérivée au moyen du modèle de prédiction d'apprentissage automatique basé sur les données d'histogramme lorsque les données d'entrée obtenues ne correspondent à aucun des scénarios de charge uniques (S1-S5).

12. Système d'estimation de l'état de santé d'une batterie rechargeable (5), le système comprenant :
une batterie rechargeable (5) ;

un ensemble de capteurs configurés pour détecter un ensemble de caractéristiques de batterie sur la batterie rechargeable (5), dans lequel l'ensemble de caractéristiques de batterie indique conjointement l'état de santé de la batterie (5) ;
une unité de commande électronique reliée à l'ensemble de capteurs et configurée pour :

obtenir des données d'entrée relatives à l'ensemble de caractéristiques de batterie prédéterminées,
appliquer une pluralité d'algorithmes d'apprentissage automatique pour effectuer une estimation de l'état de santé de la batterie (5), dans lequel chaque algorithme d'apprentissage automatique, basé sur les données d'entrée obtenues à partir des caractéristiques de batterie, calcule une estimation de l'état de santé de la batterie (5), ainsi qu'une estimation quantitative d'un intervalle/d'une valeur de confiance de l'estimation de l'état de santé de la batterie (5), et
appliquer un algorithme de fusion basé sur un filtre de Kalman pour combiner les estimations de l'état de santé provenant de tous lesdits algorithmes d'apprentissage automatique, afin de fournir une estimation fusionnée de l'état de santé.

13. Véhicule comprenant le système selon la revendication 12.

14. Unité de commande de traitement de données comprenant un processeur configuré pour exécuter les étapes du procédé selon l'une quelconque des revendications 1 à 11.

15. Programme informatique comprenant des instructions qui, lorsque le programme est exécuté par un ordinateur, amènent l'ordinateur à exécuter les étapes du procédé selon l'une quelconque des revendications 1 à 11.

FIG.1

FIG.2

FIG.3A

(a)

FIG.3B

(b)

FIG.3C

(c)

FIG.3D

(d)

FIG.3E

(e)

FIG.4A

FIG.4B

FIG.4C

Lab cell testing

Vehicle testing / Fleet data

Vehicle deployment

Offline dataflow

Online dataflow

Data processing

Feature construction

Feature engineering

Model fusion

Method: Kalman filter

Time update

Measurement update

Output fused SoH estimation

$y_k$

Model training for capacity estimation.

Model: Machine learning-based model for current step estimation.

Data: Charging curves under different scenarios in time-series

FIG.5

EP 4 390 421 B1

FIG.6

EP 4 390 421 B1

FIG.7

EP 4 390 421 B1

| Charge SoC | | |
|---|---|---|
| Average | 56.62 |
| Variance | 500.81 |
| Skewness | -0.11 |
| Kurtosis | 1.90 |
| 5th Momentum | -0.48 |
| 6th Momentum | 4.26 |
| Maximum | 15.00 |
| Minimum | 90.00 |
| Range | 75.00 |

| Charge Temperature | | |
|---|---|---|
| Average | 28.63 |
| Variance | 11.81 |
| Skewness | -1.47 |
| Kurtosis | 5.74 |
| 5th Momentum | -16.50 |
| 6th Momentum | 60.81 |
| Maximum | 9.50 |
| Minimum | 38.00 |
| Range | 28.50 |

Extracting statistic properties

Extracting statistic properties

Histogram transformation

Histogram transformation

SoC (%)

Temperature (°C)

Energy Throughput kWh

Energy Throughput kWh

Energy throughput (Kwh)

Temperature (°C)

SoC (%)

FIG.8

FIG.9

FIG.10

FIG.11

FIG.12A

Charging S1
(a)

FIG.12D

Charging S2
(d)

FIG.12E

Charging S3
(e)

FIG.12B

Charging S4
(b)

FIG.12C

Charging S5
(c)

FIG.13

EP 4 390 421 B1

FIG.14A

FIG.14B

FIG.14C

FIG.15

FIG.16A

FIG.16B

FIG.16C

FIG.16D

11 {
S40
↓
S100
↓
S200
↓
S300

FIG.17A

11 {
S20A
↓
S40
↓
S100
↓
S200
↓
S300

FIG.17B

11 {
S10
↓
S20B
↓
S40
↓
S100
↓
S200
↓
S300

FIG.17C

11 {
S10
↓
S20B
↓
S40
↓
S100
↓
S200  →  S250
↓
S300

FIG.17D

11 {
S10
↓
S20B
↓
S40

S50
↓
S60
↓
S70
↓
S80

↓
S100
↓
S200   S250
↓
S300

FIG.17E

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LIU GENGFENG**. State of health estimation of power batteries based on multi-feature fusion models using stacking algorithm. ELSEVIER, 31 July 2022, vol. 259

- **Y. PREGER** ; **H. M. BARKHOLTZ** ; **A. FRESQUEZ** ; **D. L. CAMPBELL** ; **B. W. JUBA** ; **J. ROMA'N-KUSTAS** ; **S. R. FERREIRA** ; **B. CHALAMALA, J.** Degradation of Commercial Lithium-Ion Cells as a Function of Chemistry and Cycling Conditions. Electrochem. Soc., 2020, vol. 167